# FASCICULE DE BREVET EUROPEEN

(11) **EP 4 222 870 B1**
(45) Date de publication et mention de la délivrance du brevet: **23.07.2025**
(21) Numéro de dépôt: 21786364.6
(22) Date de dépôt: 28.09.2021
(51) Int. Cl.: H04B 1/04, H04B 1/18

(54) **DISPOSITIF DE COMMANDE PAR SIGNAUX RADIOFRÉQUENCES D'UN APPAREIL ÉLECTRIQUE DOMESTIQUE, APPAREIL ÉLECTRIQUE DOMESTIQUE ET DISPOSITIF D'OCCULTATION ASSOCIÉS**
HOCHFREQUENZSIGNALSTEUERUNGSVORRICHTUNG EINES ELEKTRISCHEN HAUSHALTSGERÄTS UND ZUGEHÖRIGES ELEKTRISCHES HAUSHALTSGERÄT UND AUSTASTUNGSVORRICHTUNG
RADIOFREQUENCY SIGNAL CONTROL DEVICE OF A DOMESTIC ELECTRICAL APPARATUS, AND ASSOCIATED DOMESTIC ELECTRICAL APPARATUS AND BLANKING DEVICE

(30) Priorité: 29.09.2020 FR 2009905
(43) Date de publication de la demande: 09.08.2023
(73) Titulaire: Somfy Activites SA, 74300 Cluses (FR)
(72) Inventeur: ROBIN, Serge, 74300 CLUSES (FR)
(74) Mandataire: Lavoix
(86) Numéro de dépôt international: PCT/EP2021/076704
(87) Numéro de publication internationale: WO 2022/069494

(56) Documents cités:
- FR-A1- 3 028 693
- FR-A1- 3 061 340

## Description

La présente invention concerne un dispositif de commande par signaux radiofréquences d'un appareil électrique domestique, autrement dit un dispositif de commande pour un appareil électrique domestique. L'appareil électrique domestique est configuré pour être alimenté en énergie électrique par un réseau d'alimentation électrique du secteur.

La présente invention concerne également un appareil électrique domestique comprenant un tel dispositif de commande par signaux radiofréquences, ainsi qu'un dispositif d'occultation comprenant un tel appareil électrique domestique. L'appareil électrique domestique peut être un actionneur électromécanique pour un dispositif d'occultation, autrement dit un actionneur électromécanique d'un dispositif d'occultation.

De manière générale, la présente invention concerne le domaine des dispositifs d'occultation comprenant un dispositif d'entraînement motorisé mettant en mouvement un écran, entre au moins une première position et au moins une deuxième position.

Un dispositif d'entraînement motorisé comprend un actionneur électromécanique d'un élément mobile de fermeture, d'occultation ou de protection solaire tel qu'un volet, une porte, une grille, un store ou tout autre matériel équivalent, appelé par la suite écran.

L'appareil électrique domestique peut également être un module d'alimentation en énergie électrique pour un dispositif d'éclairage, un dispositif de chauffage et/ou de ventilation, un dispositif d'alarme ou un dispositif d'occultation, autrement dit un module d'alimentation en énergie électrique d'un dispositif d'éclairage, d'un dispositif de chauffage et/ou de ventilation, d'un dispositif d'alarme ou d'un dispositif d'occultation.

On connaît déjà le document FR 3 028 693 A1 qui décrit un dispositif de commande par signaux radiofréquences d'un appareil électrique domestique. L'appareil électrique domestique est configuré pour être alimenté en énergie électrique par un réseau d'alimentation électrique du secteur. Le dispositif de commande par signaux radiofréquences comprend un premier conducteur électrique, un deuxième conducteur électrique, une unité radiofréquences, une carte de circuit imprimé, une antenne. Chacun des premier et deuxième conducteurs électriques comprend une première extrémité et une deuxième extrémité. La première extrémité de chacun des premier et deuxième conducteurs électriques est configurée pour être reliée électriquement au réseau d'alimentation électrique du secteur. L'unité radiofréquences est configurée pour recevoir et/ou émettre des signaux radiofréquences. L'unité radiofréquences comprend une entrée et/ou une sortie des signaux radiofréquences. L'unité radiofréquences est reliée électriquement à un point de connexion. La carte de circuit imprimé comprend les premier et deuxième conducteurs électriques et le point de connexion. L'antenne est reliée électriquement à l'unité radiofréquences par l'intermédiaire d'au moins l'un des conducteurs électriques du réseau d'alimentation électrique du secteur.

Ce document décrit également que le dispositif de commande par signaux radiofréquences comprend, en outre, un coupleur. La carte de circuit imprimé comprend également le coupleur. Par ailleurs, le point de connexion fait partie intégrante du coupleur et est disposé entre ses première et deuxième extrémités. Le coupleur est configuré pour adapter l'impédance de sortie et/ou d'entrée de l'unité radiofréquences à l'impédance de l'antenne. Le coupleur est formé par une ligne de transmission imprimée sur la carte de circuit imprimé. Une première extrémité de la ligne de transmission imprimée est reliée électriquement au premier conducteur électrique. En outre, une deuxième extrémité de la ligne de transmission imprimée est reliée électriquement à une tension de référence et à l'unité radiofréquences. Ce dispositif de commande par signaux radiofréquences donne globalement satisfaction.

Cependant, ce dispositif de commande par signaux radiofréquences présente l'inconvénient de disposer le coupleur entre le premier conducteur électrique et l'unité radiofréquences.

Ainsi, une telle disposition du coupleur sur la carte de circuit imprimée provoque un encombrement sur la carte de circuit imprimé, en particulier suivant une direction longitudinale, gênant pour réduire la taille de la carte de circuit imprimé.

Par conséquent, l'emplacement occupé par le coupleur sur la carte de circuit imprimé empêche de diminuer la taille de la carte de circuit imprimé, nécessite un logement dans l'appareil électrique domestique de taille importante pour l'assemblage de la carte de circuit imprimé et le coût d'obtention de la carte de circuit imprimé du dispositif de commande par signaux radiofréquences reste onéreux.

En outre, un tel coupleur disposé sur la carte de circuit imprimé engendre des pertes radiofréquences, du point de vue de la puissance et de la sensibilité, lors de la réception et/ou de l'émission des signaux radiofréquences par le dispositif de commande par signaux radiofréquences.

Par ailleurs, un tel dispositif de commande par signaux radiofréquences présente l'inconvénient qu'un courant d'alimentation de l'appareil électrique domestique traverse le coupleur formé par la ligne de transmission imprimée.

La présente invention a pour but de résoudre les inconvénients précités et de proposer un dispositif de commande par signaux radiofréquences d'un appareil électrique domestique, ainsi qu'un appareil électrique domestique comprenant un tel dispositif de commande par signaux radiofréquences et un dispositif d'occultation comprenant un tel appareil électrique domestique, permettant d'adapter une impédance sur le premier conducteur électrique du dispositif de commande par signaux radiofréquences par rapport à une impédance d'une antenne du dispositif de commande par signaux radiofréquences, d'empêcher un rejet des signaux radiofréquences entre le premier conducteur électrique et un deuxième conducteur électrique du dispositif de commande par signaux radiofréquences, de réduire des pertes radiofréquences, du point de vue de la puissance et de la sensibilité, lors de la réception et/ou de l'émission des signaux radiofréquences par le dispositif de commande par signaux radiofréquences, tout en réduisant les dimensions d'une carte de circuit imprimé.

A cet égard, la présente invention vise, selon un premier aspect, un dispositif de commande par signaux radiofréquences d'un appareil électrique domestique, l'appareil électrique domestique étant configuré pour être alimenté en énergie électrique par un réseau d'alimentation électrique du secteur, le dispositif de commande par signaux radiofréquences comprenant au moins :
- un premier conducteur électrique et un deuxième conducteur électrique, chacun des premier et deuxième conducteurs électriques comprenant une première extrémité et une deuxième extrémité, la première extrémité de chacun des premier et deuxième conducteurs électriques étant configurée pour être reliée électriquement au réseau d'alimentation électrique du secteur,
- une unité radiofréquences, l'unité radiofréquences étant configurée pour émettre et/ou recevoir des signaux radiofréquences, l'unité radiofréquences comprenant une sortie et/ou une entrée des signaux radiofréquences, l'unité radiofréquences étant reliée électriquement à un point de connexion,
- une carte de circuit imprimé, la carte de circuit imprimé comprenant au moins le point de connexion, et
- une antenne, l'antenne étant reliée électriquement à l'unité radiofréquences par l'intermédiaire d'au moins l'un des conducteurs électriques du réseau d'alimentation électrique du secteur.

Selon l'invention, le point de connexion est disposé au niveau de la deuxième extrémité du premier conducteur électrique. Le dispositif de commande par signaux radiofréquences comprend, en outre, au moins une section de ligne d'adaptation, la section de ligne d'adaptation comprenant une première extrémité et une deuxième extrémité, la première extrémité de la section de ligne d'adaptation étant reliée électriquement au point de connexion et la deuxième extrémité de la section de ligne d'adaptation étant soit reliée électriquement à une tension de référence soit dépourvue d'une connexion électrique.

Ainsi, la section de ligne d'adaptation connectée électriquement au point de connexion disposé au niveau de la deuxième extrémité du premier conducteur électrique permet d'adapter une impédance sur le premier conducteur électrique par rapport à une impédance de l'antenne, d'empêcher un rejet des signaux radiofréquences entre les premier et deuxième conducteurs électriques du dispositif de commande par signaux radiofréquences, de réduire des pertes radiofréquences, du point de vue de la puissance et de la sensibilité, lors de la réception et/ou de l'émission des signaux radiofréquences par le dispositif de commande par signaux radiofréquences, tout en réduisant les dimensions de la carte de circuit imprimé.

De cette manière, un tel dispositif de commande par signaux radiofréquences permet de s'affranchir d'un coupleur.

Selon une caractéristique avantageuse de l'invention, la première section de ligne d'adaptation est une piste électrique de la carte de circuit imprimé.

Selon une autre caractéristique avantageuse de l'invention, la première section de ligne d'adaptation présente une longueur proche du quart de la longueur d'onde de la fréquence de travail de l'unité radiofréquences.

Selon une autre caractéristique avantageuse de l'invention, le dispositif de commande par signaux radiofréquences comprend, en outre, une autre section de ligne d'adaptation et un autre point de connexion. L'autre point de connexion est disposé au niveau de la deuxième extrémité du deuxième conducteur électrique. L'autre section de ligne d'adaptation comprend une première extrémité et une deuxième extrémité. La première extrémité de l'autre section de ligne d'adaptation est reliée électriquement à l'autre point de connexion. En outre, la deuxième extrémité de l'autre section de ligne d'adaptation est soit dépourvue d'une connexion électrique soit reliée électriquement à une tension de référence.

Selon une autre caractéristique avantageuse de l'invention, le dispositif de commande par signaux radiofréquences comprend, en outre, un circuit d'adaptation et un autre point de connexion. L'autre point de connexion est disposé au niveau de la deuxième extrémité du deuxième conducteur électrique. En outre, le circuit d'adaptation est relié électriquement, d'une part, à l'autre point de connexion et, d'autre part, est soit relié électriquement à une tension de référence soit au premier conducteur électrique.

Selon une autre caractéristique avantageuse de l'invention, le dispositif de commande par signaux radiofréquences comprend, en outre, au moins une ligne de transport des signaux radiofréquences. La ligne de transport comprend une première extrémité et une deuxième extrémité. La première extrémité de ligne de transport est reliée électriquement au premier conducteur électrique. En outre, la deuxième extrémité de ligne de transport est reliée électriquement à l'unité radiofréquences.

Selon une autre caractéristique avantageuse de l'invention, la première extrémité de la ligne de transport est reliée électriquement au point de connexion, le point de connexion étant configuré pour être relié électriquement à l'unité radiofréquences.

Selon une autre caractéristique avantageuse de l'invention, la carte de circuit imprimé porte la ligne de transport. En outre, la ligne de transport est formée par une piste électrique imprimée sur la carte de circuit imprimé.

Selon une autre caractéristique avantageuse de l'invention, le dispositif de commande par radiofréquences est dépourvu d'un coupleur disposé entre le premier conducteur électrique et l'unité radiofréquences.

La présente invention vise, selon un deuxième aspect, un appareil électrique domestique. L'appareil électrique domestique comprend au moins un dispositif de commande par signaux radiofréquences conforme à l'invention et tel que mentionné ci-dessus.

Cet appareil électrique domestique présente des caractéristiques et avantages analogues à ceux décrits précédemment, en relation avec le dispositif de commande par signaux radiofréquences selon l'invention.

Selon une caractéristique avantageuse de l'invention, l'appareil électrique domestique est un actionneur électromécanique pour un dispositif d'occultation.

En variante, l'appareil électrique domestique est un module d'alimentation en énergie électrique, le module d'alimentation en énergie électrique étant destiné à être logé à l'intérieur d'un boîtier électrique mural ou de plafond et étant configuré pour alimenter en énergie électrique un dispositif d'éclairage, un dispositif de chauffage et/ou de ventilation, un dispositif d'alarme ou un dispositif d'occultation.

La présente invention vise, selon un troisième aspect, un dispositif d'occultation. Le dispositif d'occultation comprend au moins un actionneur électromécanique formé par un appareil électrique domestique conforme à l'invention et tel que mentionné ci-dessus.

Ce dispositif d'occultation présente des caractéristiques et avantages analogues à ceux décrits précédemment, en relation avec l'appareil électrique domestique selon l'invention et avec le dispositif de commande par signaux radiofréquences selon l'invention.

D'autres particularités et avantages de l'invention apparaîtront encore dans la description ci-après.

Aux dessins annexés, donnés à titre d'exemples non limitatifs :
[Fig 1] la figure 1 est une vue schématique en coupe transversale d'une installation comprenant un dispositif d'occultation conforme à un premier mode de réalisation de l'invention ;
[Fig 2] la figure 2 est une vue schématique en perspective de l'installation illustrée à la figure 1 ;
[Fig 3] la figure 3 est une vue schématique en coupe axiale et partielle de l'installation illustrée aux figures 1 et 2, montrant un actionneur électromécanique de l'installation ;
[Fig 4] la figure 4 est un schéma électrique simplifié d'un dispositif de commande par signaux radiofréquences d'un appareil électrique domestique, à savoir l'actionneur électromécanique appartenant à l'installation illustrée aux figures 1à 3, selon le premier mode de réalisation ;
[Fig 5] la figure 5 est un schéma électrique simplifié d'un dispositif de commande par signaux radiofréquences d'un appareil électrique domestique, selon un deuxième mode de réalisation de l'invention ;
[Fig 6] la figure 6 est un schéma électrique simplifié d'un dispositif de commande par signaux radiofréquences d'un appareil électrique domestique, selon un troisième mode de réalisation de l'invention ; et
[Fig 7] la figure 7 est un schéma électrique simplifié d'un dispositif de commande par signaux radiofréquences d'un appareil électrique domestique, selon un quatrième mode de réalisation de l'invention.

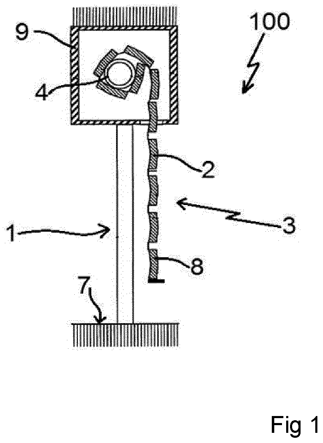

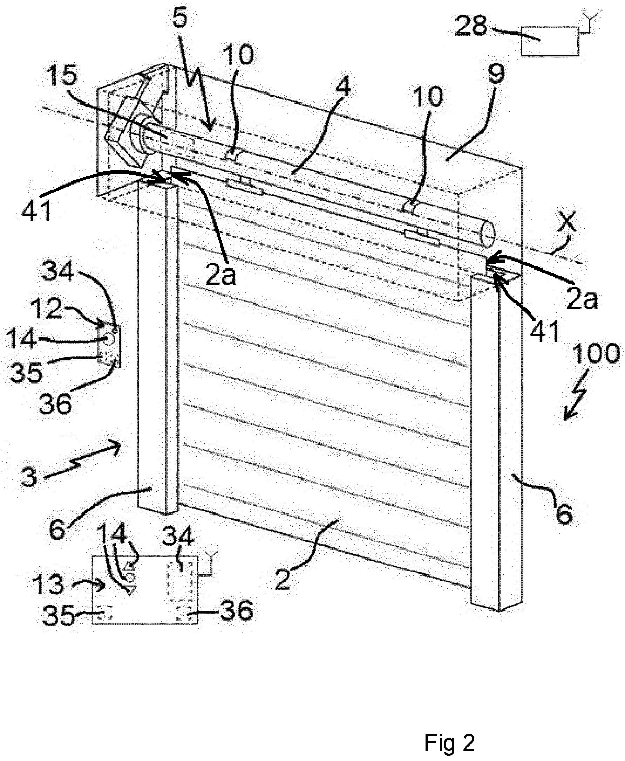

On décrit tout d'abord, en référence aux figures 1 et 2, une installation 100 comprenant un dispositif de fermeture, d'occultation ou de protection solaire 3 conforme à un premier mode de réalisation l'invention. Cette installation 100, installée dans un bâtiment, non représenté, comportant une ouverture 1, fenêtre ou porte, est équipée d'un écran 2 appartenant au dispositif de fermeture, d'occultation ou de protection solaire 3, en particulier un volet roulant motorisé.

Le dispositif de fermeture, d'occultation ou de protection solaire 3 est par la suite appelé « dispositif d'occultation ». Le dispositif d'occultation 3 comprend l'écran 2.

Le dispositif de fermeture, d'occultation ou de protection solaire 3 peut être un volet roulant, un store en toile ou avec des lames orientables, ou encore un portail roulant. La présente invention s'applique à tous les types de dispositif d'occultation.

Ici, l'installation 100 comprend le dispositif d'occultation 3.

On décrit, en référence aux figures 1 et 2, un volet roulant conforme au premier mode de réalisation de l'invention.

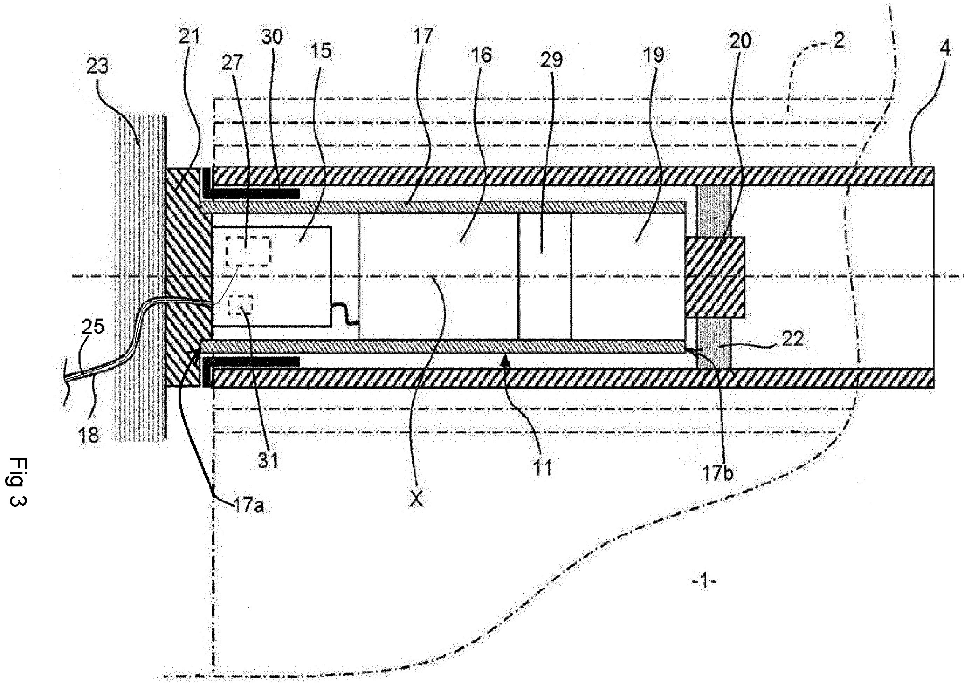

Le dispositif d'occultation 3 comprend un tube d'enroulement 4 et un dispositif d'entraînement motorisé 5. Le dispositif d'entraînement motorisé 5 comprend un actionneur électromécanique 11 illustré à la figure 3.

L'écran 2 est configuré pour être déplacé, autrement dit est déplacé, au moyen du dispositif d'entraînement motorisé 5.

Ici, l'écran 2 du dispositif d'occultation 3 est enroulé sur le tube d'enroulement 4 entraîné par le dispositif d'entraînement motorisé 5. Ainsi, l'écran 2 est mobile entre une position enroulée, en particulier haute, et une position déroulée, en particulier basse. Autrement dit, l'écran 2 est enroulable sur le tube d'enroulement 4. En outre, le tube d'enroulement 4 est agencé de sorte à être entraîné en rotation par l'actionneur électromécanique 11.

Le dispositif d'occultation 3 comprend un coffre 9.

L'écran 2 est disposé, autrement dit est configuré pour être disposé, au moins en partie à l'intérieur du coffre 9, dans une configuration assemblée du dispositif d'occultation 3.

L'écran 2 du dispositif d'occultation 3 est un écran de fermeture, d'occultation et/ou de protection solaire, s'enroulant et se déroulant autour du tube d'enroulement 4, dont le diamètre intérieur est supérieur au diamètre externe de l'actionneur électromécanique 11, de sorte que l'actionneur électromécanique 11 peut être inséré dans le tube d'enroulement 4, lors de l'assemblage du dispositif d'occultation 3.

Le dispositif d'entraînement motorisé 5 comprend l'actionneur électromécanique 11, en particulier de type tubulaire.

Celui-ci permet de mettre en rotation le tube d'enroulement 4 autour d'un axe de rotation X, de sorte à déplacer, en particulier dérouler ou enrouler, l'écran 2 du dispositif d'occultation 3.

Ainsi, l'écran 2 peut être enroulé et déroulé sur le tube d'enroulement 4. Dans l'état monté, l'actionneur électromécanique 11 est inséré dans le tube d'enroulement 4.

Avantageusement, le dispositif d'occultation 3 comprend, en outre, deux coulisses latérales 6. Chaque coulisse latérale 6 comprend une gorge 41. Chaque gorge 41 de l'une des coulisses latérales 6 coopère, autrement dit est configurée pour coopérer, avec un bord latéral 2a de l'écran 2, dans la configuration assemblée du dispositif d'occultation 3, de sorte à guider l'écran 2, lors du déplacement, en particulier de l'enroulement et du déroulement, de l'écran 2, en particulier autour du tube d'enroulement 4.

De manière connue, le volet roulant, qui forme le dispositif d'occultation 3, comporte un tablier comprenant des lames horizontales articulées les unes aux autres, formant l'écran 2 du volet roulant 3, et guidées par les deux coulisses latérales 6. Ces lames sont jointives lorsque le tablier 2 du volet roulant 3 atteint sa position basse déroulée.

Dans le cas d'un volet roulant, la position haute enroulée correspond à la mise en appui d'une lame d'extrémité finale 8, par exemple en forme de L, du tablier 2 du volet roulant 3 contre un bord du coffre 9 du volet roulant 3 ou à l'arrêt de la lame d'extrémité finale 8 dans une position de fin de course haute programmée. En outre, la position basse déroulée correspond à la mise en appui de la lame d'extrémité finale 8 du tablier 2 du volet roulant 3 contre un seuil 7 de l'ouverture 1 ou à l'arrêt de la lame d'extrémité finale 8 dans une position de fin de course basse programmée.

La première lame du volet roulant 3, opposée à la lame d'extrémité finale 8, est reliée au tube d'enroulement 4 au moyen d'au moins une articulation 10, en particulier une pièce d'attache en forme de bande.

Le tube d'enroulement 4 est disposé à l'intérieur du coffre 9 du volet roulant 3. Le tablier 2 du volet roulant 3 s'enroule et se déroule autour du tube d'enroulement 4 et est logé au moins en partie à l'intérieur du coffre 9.

De manière générale, le coffre 9 est disposé au-dessus de l'ouverture 1, ou encore en partie supérieure de l'ouverture 1.

Le dispositif d'entraînement motorisé 5 est commandé par une unité de commande. L'unité de commande peut être, par exemple, une unité de commande locale 12.

L'unité de commande locale 12 peut être reliée en liaison filaire ou non filaire avec une unité de commande centrale 13. L'unité de commande centrale 13 pilote l'unité de commande locale 12, ainsi que d'autres unités de commande locales similaires et réparties dans le bâtiment.

Le dispositif d'entraînement motorisé 5 est, de préférence, configuré pour exécuter les commandes de déplacement, notamment de déroulement ou d'enroulement, de l'écran 2 du dispositif d'occultation 3, pouvant être émises, notamment, par l'unité de commande locale 12 ou l'unité de commande centrale 13.

L'installation 100 comprend soit l'unité de commande locale 12, soit l'unité de commande centrale 13, soit l'unité de commande locale 12 et l'unité de commande centrale 13.

On décrit à présent, plus en détail et en référence à la figure 3, le dispositif d'entraînement motorisé 5, y compris l'actionneur électromécanique 11, appartenant à l'installation 100 des figures 1 et 2.

L'actionneur électromécanique 11 comprend un moteur électrique 16.

Avantageusement, le moteur électrique 16 comprend un rotor et un stator, non représentés et positionnés de manière coaxiale autour de l'axe de rotation X, qui est également l'axe de rotation du tube d'enroulement 4 en configuration montée du dispositif d'entraînement motorisé 5.

Des moyens de commande de l'actionneur électromécanique 11, permettant le déplacement de l'écran 2 du dispositif d'occultation 3, sont constitués par au moins une unité électronique de contrôle 15. Cette unité électronique de contrôle 15 appartient à l'actionneur électromécanique 11 et est apte à mettre en fonctionnement le moteur électrique 16 de l'actionneur électromécanique 11 et, en particulier, à permettre l'alimentation en énergie électrique du moteur électrique 16.

Ainsi, l'unité électronique de contrôle 15 commande, notamment, le moteur électrique 16, de sorte à ouvrir ou fermer l'écran 2, comme décrit précédemment.

Les moyens de commande de l'actionneur électromécanique 11 comprennent des moyens matériels et/ou logiciels.

A titre d'exemple nullement limitatif, les moyens matériels peuvent comprendre au moins un microcontrôleur 31, illustré à la figure 3.

Le dispositif d'entraînement motorisé 5 comprend l'unité électronique de contrôle 15. L'unité électronique de contrôle 15 est reliée électriquement au moteur électrique 16. L'unité électronique de contrôle 15 est disposée à l'intérieur du coffre 9, dans la configuration assemblée du dispositif d'occultation 3.

L'unité électronique de contrôle 15 comprend, en outre, un premier module de communication 27, comme illustré à la figure 3, en particulier de réception d'ordres de commande, les ordres de commande étant émis par un émetteur d'ordres, tel que l'unité de commande locale 12 ou l'unité de commande centrale 13, ces ordres étant destinés à commander le dispositif d'entraînement motorisé 5.

Le premier module de communication 27 de l'unité électronique de contrôle 15 est de type sans fil. Le premier module de communication 27 est configuré pour recevoir des ordres de commande radioélectriques.

Le dispositif d'entraînement motorisé 5 comprend une antenne 25, dite radioélectrique. L'antenne 25 est reliée électriquement à l'unité électronique de contrôle 15 et, plus particulièrement, au premier module de communication 27.

Avantageusement, le premier module de communication 27 peut également permettre la réception d'ordres de commande transmis par des moyens filaires.

L'unité électronique de contrôle 15, l'unité de commande locale 12 et/ou l'unité de commande centrale 13 peuvent être en communication avec une station météorologique déportée à l'extérieur du bâtiment, incluant, notamment, un ou plusieurs capteurs pouvant être configurés pour déterminer, par exemple, une température, une luminosité ou encore une vitesse de vent.

L'unité électronique de contrôle 15, l'unité de commande locale 12 et/ou l'unité de commande centrale 13 peuvent également être en communication avec un serveur 28, de sorte à contrôler l'actionneur électromécanique 11 suivant des données mises à disposition à distance par l'intermédiaire d'un réseau de communication, en particulier un réseau internet pouvant être relié au serveur 28.

L'unité électronique de contrôle 15 peut être commandée à partir de l'unité de commande locale 12 et/ou centrale 13. L'unité de commande locale 12 et/ou centrale 13 est pourvue d'un clavier de commande. Le clavier de commande de l'unité de commande locale 12 ou centrale 13 comprend un ou plusieurs éléments de sélection 14 et, éventuellement, un ou plusieurs éléments d'affichage 34.

A titre d'exemples nullement limitatifs, les éléments de sélection peuvent être des boutons poussoirs ou des touches sensitives, les éléments d'affichage peuvent être des diodes électroluminescentes, un afficheur LCD (acronyme du terme anglo-saxon « Liquid Crystal Display ») ou TFT (acronyme du terme anglo-saxon « Thin Film Transistor »). Les éléments de sélection et d'affichage peuvent être également réalisés au moyen d'un écran tactile.

L'unité de commande locale 12 et/ou centrale 13 comprend au moins un deuxième module de communication 36.

Ainsi, le deuxième module de communication 36 de l'unité de commande locale 12 ou centrale 13 est configuré pour émettre, autrement dit émet, des ordres de commande, par des moyens sans fil, en l'occurrence radioélectriques, et, éventuellement, par des moyens filaires.

En outre, le deuxième module de communication 36 de l'unité de commande locale 12 ou centrale 13 peut également être configuré pour recevoir, autrement dit reçoit, des ordres de commande, en particulier par l'intermédiaire des mêmes moyens.

Le deuxième module de communication 36 de l'unité de commande locale 12 ou centrale 13 est configuré pour communiquer, autrement dit communique, avec le premier module de communication 27 de l'unité électronique de contrôle 15.

Ainsi, le deuxième module de communication 36 de l'unité de commande locale 12 ou centrale 13 échange des ordres de commande avec le premier module de communication 27 de l'unité électronique de contrôle 15, soit de manière monodirectionnelle soit de manière bidirectionnelle.

Avantageusement, l'unité de commande locale 12 est un point de commande, pouvant être fixe ou nomade. Un point de commande fixe peut être un boîtier de commande destiné à être fixé sur une façade d'un mur du bâtiment ou sur une face d'un cadre dormant d'une fenêtre ou d'une porte. Un point de commande nomade peut être une télécommande, un téléphone intelligent ou une tablette.

Avantageusement, l'unité de commande locale 12 et/ou centrale 13 comprend, en outre, un contrôleur 35.

Le dispositif d'entraînement motorisé 5, en particulier l'unité électronique de contrôle 15, est, de préférence, configuré pour exécuter des ordres de commande de déplacement, notamment de fermeture ainsi que d'ouverture, de l'écran 2 du dispositif d'occultation 3. Ces ordres de commande peuvent être émis, notamment, par l'unité de commande locale 12 ou par l'unité de commande centrale 13.

Le dispositif d'entraînement motorisé 5 peut être contrôlé par l'utilisateur, par exemple par la réception d'un ordre de commande correspondant à un appui sur le ou l'un des éléments de sélection 14 de l'unité de commande locale 12 ou centrale 13.

Le dispositif d'entraînement motorisé 5 peut également être contrôlé automatiquement, par exemple par la réception d'un ordre de commande correspondant à au moins un signal provenant d'au moins un capteur et/ou à un signal provenant d'une horloge de l'unité électronique de contrôle 15, en particulier du microcontrôleur 31. Le capteur et/ou l'horloge peuvent être intégrés à l'unité de commande locale 12 ou à l'unité de commande centrale 13.

Avantageusement, l'actionneur électromécanique 11 comprend un carter 17, en particulier tubulaire. Le moteur électrique 16 est monté à l'intérieur du carter 17, en particulier dans une configuration assemblée de l'actionneur électromécanique 11.

Ici, le carter 17 de l'actionneur électromécanique 11 est de forme cylindrique, notamment de révolution autour de l'axe de rotation X.

Dans un mode de réalisation, le carter 17 est réalisé dans un matériau métallique.

La matière du carter de l'actionneur électromécanique n'est pas limitative et peut être différente. Il peut s'agir, en particulier, d'une matière plastique.

Avantageusement, l'actionneur électromécanique 11 comprend, en outre, un réducteur 19 et un arbre de sortie 20.

Avantageusement, l'actionneur électromécanique 11 comprend, en outre, un frein 29.

A titre d'exemple nullement limitatif, le frein 29 peut être un frein à ressort, un frein à came, un frein magnétique ou un frein électromagnétique.

Ici et comme visible à la figure 3, dans la configuration assemblée de l'actionneur électromécanique 11, le frein 29 est configuré pour être disposé, autrement dit est disposé, entre le moteur électrique 16 et le réducteur 19, c'est-à-dire à la sortie du moteur électrique 16.

En variante, non représentée, dans la configuration assemblée de l'actionneur électromécanique 11, le frein 29 est configuré pour être disposé, autrement dit est disposé, entre l'unité électronique de contrôle 15 et le moteur électrique 16, autrement dit à l'entrée du moteur électrique 16, entre le réducteur 19 et l'arbre de sortie 20, autrement dit à la sortie du réducteur 19, ou entre deux étages de réduction du réducteur 19.

Avantageusement, le moteur électrique 16, le frein 29 et le réducteur 19 sont configurés pour être montés, autrement dit sont montés, à l'intérieur du carter 17 de l'actionneur électromécanique 11, dans la configuration assemblée de l'actionneur électromécanique 11.

L'actionneur électromécanique 11 peut également comprendre un dispositif, non représenté, de détection de fin de course et/ou d'obstacle, ce dispositif pouvant être mécanique ou électronique.

Le tube d'enroulement 4 est entraîné en rotation autour de l'axe de rotation X et du carter 17 de l'actionneur électromécanique 11 en étant soutenu par l'intermédiaire de deux liaisons pivot. La première liaison pivot est réalisée au niveau d'une première extrémité du tube d'enroulement 4 au moyen d'une couronne 30 insérée autour d'une première extrémité 17a du carter 17 de l'actionneur électromécanique 11. La couronne 30 permet ainsi de réaliser un palier. La deuxième liaison pivot, non représentée à la figure 3, est réalisée au niveau d'une deuxième extrémité du tube d'enroulement 4, non visible sur cette figure.

Avantageusement, l'actionneur électromécanique 11 comprend un support de couple 21. Le support de couple 21 est en saillie au niveau de la première extrémité 17a du carter 17 de l'actionneur électromécanique 11, en particulier l'extrémité 17a du carter 17 recevant la couronne 30. Le support de couple 21 de l'actionneur électromécanique 11 permet ainsi de fixer l'actionneur électromécanique 11 sur un bâti 23, en particulier à une joue du coffre 9.

En outre, le support de couple 21 de l'actionneur électromécanique 11 peut permettre d'obturer la première extrémité 17a du carter 17.

Par ailleurs, le support de couple 21 de l'actionneur électromécanique 11 peut permettre de supporter l'unité électronique de contrôle 15. L'unité électronique de contrôle 15 peut être alimentée en énergie électrique au moyen d'un câble d'alimentation électrique 18.

Ici et tel qu'illustré à la figure 3, l'unité électronique de contrôle 15 est ainsi disposée, autrement dit intégrée, à l'intérieur du carter 17 de l'actionneur électromécanique 11.

En variante, non représentée, l'unité électronique de contrôle 15 est disposée à l'extérieur du carter 17 de l'actionneur électromécanique 11 et, en particulier, montée sur le coffre 9 ou dans le support de couple 21.

Avantageusement, l'arbre de sortie 20 de l'actionneur électromécanique 11 est disposé à l'intérieur du tube d'enroulement 4 et au moins en partie à l'extérieur du carter 17 de l'actionneur électromécanique 11.

Avantageusement, une extrémité de l'arbre de sortie 20 est en saillie par rapport au carter 17 de l'actionneur électromécanique 11, en particulier par rapport à une deuxième extrémité 17b du carter 17 opposée à la première extrémité 17a.

Avantageusement, l'arbre de sortie 20 de l'actionneur électromécanique 11 est configuré pour entraîner en rotation un élément de liaison 22 relié au tube d'enroulement 4. L'élément de liaison 22 est réalisé sous la forme d'une roue.

Lors de la mise en fonctionnement de l'actionneur électromécanique 11, le moteur électrique 16 et le réducteur 19 entraînent en rotation l'arbre de sortie 20. En outre, l'arbre de sortie 20 de l'actionneur électromécanique 11 entraîne en rotation le tube d'enroulement 4 par l'intermédiaire de l'élément de liaison 22.

Ainsi, le tube d'enroulement 4 entraîne en rotation l'écran 2 du dispositif d'occultation 3, de sorte à ouvrir ou fermer l'ouverture 1.

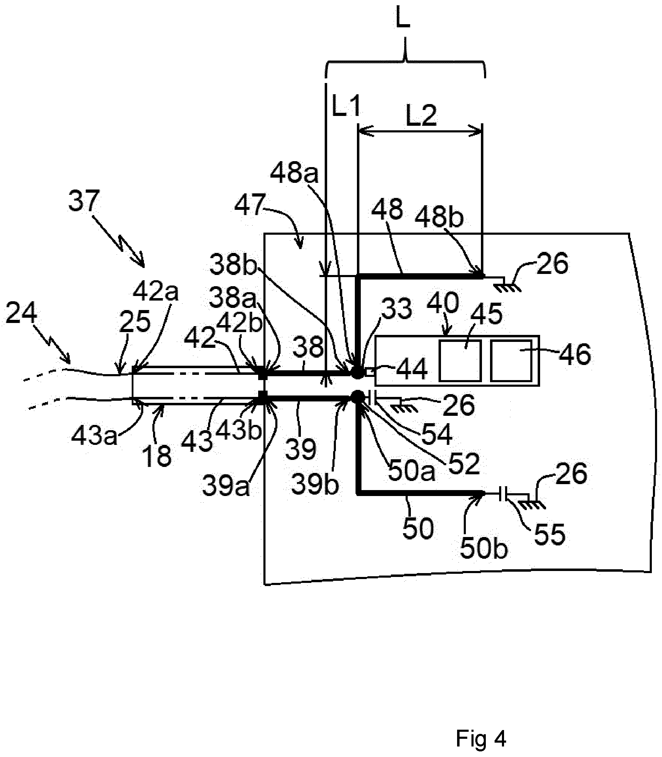

On décrit à présent, en référence à la figure 4, un dispositif de commande par signaux radiofréquences 37 d'un appareil électrique domestique.

Dans un exemple de réalisation, cet appareil électrique domestique est formé par l'actionneur électromécanique 11, illustré à la figure 3, appartenant à l'installation des figures 1 et 2.

De manière particulière, l'unité électronique de contrôle 15 de l'actionneur électromécanique 11, en particulier le premier module de communication 27, comprend une partie du dispositif de commande par signaux radiofréquences 37.

Ainsi, le dispositif de commande par signaux radiofréquences 37 appartient à l'actionneur électromécanique 11.

L'appareil électrique domestique est configuré pour être alimenté, autrement dit est alimenté, en énergie électrique par un réseau d'alimentation électrique du secteur 24, à travers le câble d'alimentation électrique 18.

Ici, le courant du réseau d'alimentation électrique du secteur 24 est de type alternatif basse fréquence, par exemple de l'ordre de 50Hz ou de 60Hz, dont l'intensité peut varier en fonction du mode de fonctionnement de l'actionneur électromécanique 11.

En outre, le courant du réseau d'alimentation électrique du secteur 24 est configuré pour alimenter, autrement dit alimente, l'actionneur électromécanique 11 et, en particulier, le moteur électrique 16 de l'actionneur électromécanique 11 et l'unité électronique de contrôle 15.

Ici, le dispositif de commande par signaux radiofréquences 37 est logé à l'intérieur du carter 17 de l'actionneur électromécanique 11. Plus particulièrement, le support de couple 21 de l'actionneur électromécanique 11 supporte le dispositif de commande par signaux radiofréquences 37.

Le câble d'alimentation électrique 18 de l'actionneur électromécanique 11 comprend au moins deux conducteurs électriques 42, 43.

Ici, le conducteur électrique 42 du câble d'alimentation électrique 18 est appelé par la suite premier conducteur électrique du câble d'alimentation électrique 18. En outre, le conducteur électrique 43 du câble d'alimentation électrique 18 est appelé par la suite deuxième conducteur électrique du câble d'alimentation électrique 18.

Chacun des premier et deuxième conducteurs électriques 42, 43 du câble d'alimentation électrique 18 comprend une première extrémité 42a, 43a et une deuxième extrémité 42b, 43b. La première extrémité 42a du premier conducteur électrique 42 est distincte et, en particulier, opposée à la deuxième extrémité 42b du premier conducteur électrique 42. En outre, la première extrémité 43a du deuxième conducteur électrique 43 est distincte et, en particulier, opposée à la deuxième extrémité 43b du deuxième conducteur électrique 43.

Ici, le câble d'alimentation électrique 18 fait partie intégrante du dispositif de commande par signaux radiofréquences 37. Autrement dit, le dispositif de commande par signaux radiofréquences 37 comprend le câble d'alimentation électrique 18.

Le câble d'alimentation électrique 18 traverse le support de couple 21 de l'actionneur électromécanique 11 au niveau d'une ouverture de passage, non représentée, et est connecté électriquement à l'unité électronique de contrôle 15.

Dans un mode de réalisation, le câble d'alimentation électrique 18 est connecté électriquement à l'unité électronique de contrôle 15 par l'emboîtement d'un connecteur électrique du câble d'alimentation électrique 18 sur un connecteur électrique de l'unité électronique de contrôle 15.

En variante, le câble d'alimentation électrique 18 est connecté électriquement à l'unité électronique de contrôle 15 par l'insertion des premier et deuxième conducteurs électriques 42, 43 du câble d'alimentation électrique 18 dans un connecteur électrique de l'unité électronique de contrôle 15.

Le dispositif de commande par signaux radiofréquences 37 comprend au moins un premier conducteur électrique 38 et un deuxième conducteur électrique 39.

Ici, les premier et deuxième conducteurs électriques 38, 39 sont configurés pour alimenter, autrement dit alimentent, en énergie électrique certains autres composants du dispositif de commande par signaux radiofréquences 37.

Ainsi, les premier et deuxième conducteurs électriques 38, 39 du dispositif de commande par signaux radiofréquences 37 sont reliés électriquement au réseau d'alimentation électrique du secteur 24, et, en particulier, aux premier et deuxième conducteurs électriques 42, 43 du câble d'alimentation électrique 18.

De cette manière, le dispositif de commande par signaux radiofréquences 37 est alimenté en énergie électrique par le réseau d'alimentation électrique du secteur 24.

Avantageusement, les premier et deuxième conducteurs électriques 42, 43 du câble d'alimentation électrique 18 correspondent à un conducteur électrique de phase et à un conducteur électrique de neutre.

Avantageusement, le câble d'alimentation électrique 18 peut comprendre, en outre, un conducteur électrique de protection, non représenté. Le conducteur électrique de protection du câble d'alimentation électrique 18 est relié à la terre et à une structure métallique de l'actionneur électromécanique 11, telle que, par exemple, le carter 17 de l'actionneur électromécanique 11.

Chacun des premier et deuxième conducteurs électriques 38, 39 comprend une première extrémité 38a, 39a et une deuxième extrémité 38b, 39b. La première extrémité 38a du premier conducteur électrique 38 est distincte et, en particulier, opposée à la deuxième extrémité 38b du premier conducteur électrique 38. En outre, la première extrémité 39a du deuxième conducteur électrique 39 est distincte et, en particulier, opposée à la deuxième extrémité 39b du deuxième conducteur électrique 39.

La première extrémité 38a, 39a de chacun des premier et deuxième conducteurs électriques 38, 39 est configurée pour être reliée électriquement, autrement dit est reliée électriquement, au réseau d'alimentation électrique du secteur 24, en particulier aux conducteurs électriques du réseau d'alimentation électrique du secteur 24 et, plus particulièrement, aux premier et deuxième conducteurs électriques 42, 43 du câble d'alimentation électrique 18.

Le dispositif de commande par signaux radiofréquences 37 comprend une unité radiofréquences 40. L'unité radiofréquences 40 est configurée pour recevoir et/ou émettre, autrement dit reçoit et/ou émet, des signaux radiofréquences, autrement dit des signaux véhiculés par ondes radiofréquences. L'unité radiofréquences 40 comprend une entrée et/ou sortie 44 des signaux radiofréquences, autrement dit une entrée, une sortie ou une entrée et une sortie. L'unité radiofréquences 40 est reliée électriquement à un point de connexion 33.

Ici, le point de connexion 33 est appelé par la suite premier point de connexion.

Avantageusement, des signaux radiofréquences proviennent d'un émetteur, non représenté, de l'unité de commande locale 12 et/ou centrale 13 ou d'un capteur et sont émis en direction de l'unité radiofréquences 40. En outre, des signaux radiofréquences proviennent de l'unité radiofréquences 40 et sont émis en direction d'un récepteur, non représenté, de l'unité de commande locale 12 et/ou centrale 13 ou d'un capteur.

Ici, l'émetteur et, éventuellement, le récepteur de l'unité de commande locale 12 et/ou centrale 13 ou d'un capteur font partie du deuxième module de communication 36, illustré à la figure 2.

Avantageusement, les signaux radiofréquences émis par l'unité de commande locale 12 et/ou centrale 13 ou par un capteur comportent des ordres de commande de l'actionneur électromécanique 11 ou des données à transmettre à l'actionneur électromécanique 11. En outre, les signaux radiofréquences émis par l'unité radiofréquences 40 comportent des données relatives au fonctionnement de l'actionneur électromécanique 11.

Ici, les ordres de commande reçus par l'unité radiofréquences 40 sont traités par celle-ci et transmis par une connexion électrique à partir de l'unité électronique de contrôle 15 au moteur électrique 16, de sorte à commander un déplacement de l'écran 2, soit dans un premier sens de déplacement, par exemple de montée, soit dans un deuxième sens de déplacement, par exemple de descente, ou encore à arrêter un déplacement de l'écran 2.

Ainsi, le dispositif de commande par signaux radiofréquences 37 permet de mettre en œuvre une communication bidirectionnelle, de sorte à échanger des ordres de commande ou des données en réception et en émission avec l'unité de commande locale 12 et/ou centrale 13 ou un capteur.

En variante, le dispositif de commande par signaux radiofréquences 37 permet uniquement de mettre en œuvre une communication monodirectionnelle, de sorte à recevoir des ordres de commande de l'unité de commande locale 12 et/ou centrale 13 ou d'un capteur.

Les signaux radiofréquences visés dans le cadre de la présente description sont, préférentiellement, de type hertzien.

Avantageusement, l'unité radiofréquences 40 comprend, en outre, un circuit d'alimentation 45 et un circuit radiofréquences 46.

Avantageusement, le circuit d'alimentation 45 de l'unité radiofréquences 40 est configuré pour être alimenté, autrement dit est alimenté, en énergie électrique par le réseau d'alimentation électrique du secteur 24 et, en particulier, par les premier et deuxième conducteurs électriques 38, 39 du dispositif de commande par signaux radiofréquences 37 reliés électriquement aux premier et deuxième conducteurs électriques 42, 43 du câble d'alimentation électrique 18, lui-même relié au réseau d'alimentation électrique du secteur 24.

Avantageusement, le circuit d'alimentation 45 de l'unité radiofréquences 40 comprend des éléments, non représentés, de transformation de la tension du réseau d'alimentation électrique du secteur 24 en une tension interne à l'unité radiofréquences 40. En outre, la tension interne à l'unité radiofréquences 40 est configurée pour alimenter, autrement dit alimente, en énergie électrique le circuit radiofréquences 46 de l'unité radiofréquences 40.

A titre d'exemple nullement limitatif, la tension interne à l'unité radiofréquences 40 peut être de l'ordre de +5V.

Avantageusement, le circuit radiofréquences 46 de l'unité radiofréquences 40 comprend les éléments, non représentés, nécessaires à la réception et/ou à l'émission de signaux radiofréquences sur l'entrée et/ou la sortie 44 de signaux radiofréquences.

Le dispositif de commande par signaux radiofréquences 37 comprend, en outre, une carte de circuit imprimé 47. La carte de circuit imprimé 47 comprend au moins le premier point de connexion 33.

Ici, la carte de circuit imprimée 47 fait partie de l'unité électronique de contrôle 15.

Ici, la carte de circuit imprimé 47 porte, autrement dit comprend, les premier et deuxième conducteurs électriques 38, 39.

Avantageusement, la carte de circuit imprimé 47 porte, autrement dit comprend, l'unité radiofréquences 40.

Avantageusement, les premier et deuxième conducteurs électriques 42, 43 du câble d'alimentation électrique 18 sont reliés électriquement à des pistes électriques de la carte de circuit imprimé 47. En outre, les premier et deuxième conducteurs électriques 38, 39 du dispositif de commande par signaux radiofréquences 37 sont des pistes électriques de la carte de circuit imprimé 47.

Ainsi, les premier et deuxième conducteurs électriques 38, 39 du dispositif de commande par signaux radiofréquences 37 permettent d'alimenter en énergie électrique d'autres composants portés par la carte de circuit imprimé 47, en l'occurrence d'autres composants du dispositif de commande par signaux radiofréquences 37 et de l'unité électronique de contrôle 15, ainsi que le moteur électrique 16 de l'actionneur électromécanique 11.

Les pistes électriques de la carte de circuit imprimé 47 correspondent à des bandes métalliques permettant de créer des liaisons électriques. Ces pistes électriques sont généralement réalisées au niveau d'une surface de la carte de circuit imprimé 47.

Le dispositif de commande par signaux radiofréquences 37 comprend, en outre, l'antenne 25. L'antenne 25 est reliée électriquement à l'unité radiofréquences 40 par l'intermédiaire d'au moins l'un des conducteurs électriques du réseau d'alimentation électrique du secteur 24 et, éventuellement, d'au moins l'un des premier et deuxième conducteurs électriques 42, 43 du câble d'alimentation électrique 18.

Avantageusement, l'antenne 25 comporte, autrement dit est constituée par, au moins l'un des premier et deuxième conducteurs électriques 42, 43 du câble d'alimentation électrique 18 et au moins l'un des conducteurs électriques du réseau d'alimentation électrique du secteur 24. Cette antenne 25 est de longueur indéterminée pour les signaux radiofréquences.

Avantageusement, l'antenne 25 permet de capter des signaux radiofréquences émis par l'émetteur de l'unité de commande locale 12 et/ou centrale 13 ou d'un capteur et/ou d'émettre des signaux radiofréquences en direction du récepteur de l'unité de commande locale 12 et/ou centrale 13 ou d'un capteur.

Les signaux radiofréquences sont reçus et/ou émis par l'unité radiofréquences 40 et, en particulier, au moyen de l'antenne 25 par une transmission aérienne.

Ici, le premier point de connexion 33 est disposé au niveau de la deuxième extrémité 38b du premier conducteur électrique 38.

Le dispositif de commande par signaux radiofréquences 37 comprend, en outre, au moins une section de ligne d'adaptation 48. La section de ligne d'adaptation 48 est communément appelée « stub ».

Ici, la section de ligne d'adaptation 48 est appelée par la suite première section de ligne d'adaptation.

La première section de ligne d'adaptation 48 comprend une première extrémité 48a et une deuxième extrémité 48b. La première extrémité 48a est distincte et, en particulier, opposée à la deuxième extrémité 48b. La première extrémité 48a de la première section de ligne d'adaptation 48 est reliée électriquement au premier point de connexion 33.

Ici, la deuxième extrémité 48b de la première section de ligne d'adaptation 48 est reliée électriquement à une tension de référence 26, ici à une masse.

Dans un tel cas, la première section de ligne d'adaptation 48 est dite fermée ou en court-circuit.

En variante, non représentée, la deuxième extrémité 48b de la première section de ligne d'adaptation 48 est dépourvue d'une connexion électrique, en particulier à un élément du dispositif de commande par signaux radiofréquences 37. Le potentiel de la deuxième extrémité 48b de la première section de ligne d'adaptation 48 est alors dit « flottant ».

Dans un tel cas, la première section de ligne d'adaptation 48 est dite ouverte.

La première section de ligne d'adaptation 48 connectée électriquement au premier point de connexion 33 permet ainsi d'adapter une impédance sur le premier conducteur électrique 38 par rapport à une impédance de l'antenne 25, d'empêcher un rejet des signaux radiofréquences entre les premier et deuxième conducteurs électriques 38, 39 du dispositif de commande par signaux radiofréquences 37, de réduire des pertes radiofréquences, du point de vue de la puissance et de la sensibilité, lors de la réception et/ou de l'émission des signaux radiofréquences par le dispositif de commande par signaux radiofréquences 37, tout en réduisant les dimensions de la carte de circuit imprimé 47.

De cette manière, le dispositif de commande par signaux radiofréquences 37 permet de s'affranchir d'un coupleur. En d'autres termes, le dispositif de commande par radiofréquences 37 est dépourvu d'un coupleur disposé entre le premier conducteur électrique 38, 42 et l'unité radiofréquences 40, ce coupleur étant configuré, notamment, pour adapter une impédance par rapport à une impédance de l'unité radiofréquences 40.

En outre, la première section de ligne d'adaptation 48 est configurée pour ne pas être traversée, autrement dit n'est pas traversée, par le courant du réseau d'alimentation électrique du secteur 24 circulant dans l'un des conducteurs électriques du réseau d'alimentation électrique du secteur 24, dans le premier conducteur électrique 42 du câble d'alimentation électrique 18, puis dans le premier conducteur électrique 38 du dispositif de commande par signaux radiofréquences 37.

De cette manière, les dimensions de la première section de ligne d'adaptation 48 peuvent être minimisées, de même que celles de la carte de circuit imprimé 47.

Par ailleurs, la première section de ligne d'adaptation 48 est configurée pour ne pas être traversée, autrement dit n'est pas traversée, par les signaux radiofréquences circulant dans l'un des conducteurs électriques du réseau d'alimentation électrique du secteur 24, dans le premier conducteur électrique 42 du câble d'alimentation électrique 18, dans le premier conducteur électrique 38 du dispositif de commande par signaux radiofréquences 37 puis dans l'entrée et/ou sortie 44 de l'unité radiofréquences 40.

Avantageusement, les dimensions de la première section de ligne d'adaptation 48 sont de petite taille, dans le cas où la fréquence de travail de l'unité radiofréquences 40 est supérieure à 1 GHz, par exemple de l'ordre de 2,4 GHz.

Avantageusement, la première section de ligne d'adaptation 48 peut être de type inductif ou capacitif.

Avantageusement, la première section de ligne d'adaptation 48 est une piste électrique de la carte de circuit imprimé 47.

Avantageusement, la première section de ligne d'adaptation 48 permet de pouvoir faire fonctionner le dispositif de commande par signaux radiofréquences 37 dans une bande de signaux radiofréquences élevée, pouvant être supérieure à 1 GHz, par exemple de l'ordre de 2,4 GHz.

La piste de la carte de circuit imprimé 47 formant la première section de ligne d'adaptation 48 présente une longueur L permettant d'adapter l'impédance sur le premier conducteur électrique 38 par rapport à une impédance de l'antenne 25.

Avantageusement, la longueur L de la première section de ligne d'adaptation 48 est proche du quart de la longueur d'onde de la fréquence de travail de l'unité radiofréquences 40.

Par proche, on entend que le rapport de la longueur L sur la longueur d'onde de la fréquence de travail de l'unité radiofréquences 40 est compris entre 0,5 et 1,5, de préférence entre 0,8 et 1,2, de préférence encore entre 0,9 et 1,1.

Avantageusement, la première section de ligne d'adaptation 48 est de type inductif si la longueur L de celle-ci est inférieure au quart de la longueur d'onde de la fréquence de travail de l'unité radiofréquences 40 et si la deuxième extrémité 48b de la première section de ligne d'adaptation 48 est reliée électriquement à la tension de référence 26. En outre, la première section de ligne d'adaptation 48 est de type capacitif si la longueur de celle-ci est supérieure au quart de la longueur d'onde de la fréquence de travail de l'unité radiofréquences 40 et la deuxième extrémité 48b de la première section de ligne d'adaptation 48 est reliée électriquement à la tension de référence 26.

Avantageusement, la première section de ligne d'adaptation 48 est de type capacitif si la longueur L de celle-ci est inférieure au quart de la longueur d'onde de la fréquence de travail de l'unité radiofréquences 40 et si la deuxième extrémité 48b de la première section de ligne d'adaptation 48 est dépourvue d'une connexion électrique. En outre, la première section de ligne d'adaptation 48 est de type inductif si la longueur de celle-ci est supérieure au quart de la longueur d'onde de la fréquence de travail de l'unité radiofréquences 40 et la deuxième extrémité 48b de la première section de ligne d'adaptation 48 est dépourvue d'une connexion électrique.

La longueur L de la première section de ligne d'adaptation 48 est dépendante de la fréquence de travail de l'unité radiofréquences 40.

La longueur L de la première section de ligne d'adaptation 48 peut également être dépendante du type de substrat constituant la carte de circuit imprimé 47, ainsi que de la permittivité relative par rapport à l'air du substrat constituant la carte de circuit imprimé 47.

Dans un cas où la valeur d'impédance caractéristique de la première section de ligne d'adaptation 48 est de l'ordre de 50 Ohms et que la fréquence de travail de l'unité radiofréquences 40 est de l'ordre de 2,45 GHz, la longueur L de la première section de ligne d'adaptation 48 est de l'ordre de 30 millimètres.

Dans un autre cas où la valeur d'impédance caractéristique de la première section de ligne d'adaptation 48 est de l'ordre de 50 Ohms et que la fréquence de travail de l'unité radiofréquences 40 est de l'ordre de 868 MHz, la longueur L de la première section de ligne d'adaptation 48 est de l'ordre de 86 millimètres.

La fréquence de réception et/ou d'émission de signaux radioélectriques peut être différente et comprise dans une plage s'étendant entre 400 MHz et 6 GHz, et pouvant prendre, notamment, des valeurs de l'ordre de 433 MHz.

A titre d'exemple nullement limitatif, le substrat de la carte de circuit imprimé 47 est réalisé en époxy et est, en particulier, de type FR4. Et la permittivité relative par rapport à l'air du substrat de la carte de circuit imprimé 47 est de 4,3.

Avantageusement, le premier conducteur électrique 42 du câble d'alimentation électrique 18, relié électriquement au premier conducteur électrique 38 du dispositif de commande par signaux radiofréquences 37, est un conducteur électrique de neutre. En outre, le deuxième conducteur électrique 43 du câble d'alimentation électrique 18, relié électriquement au deuxième conducteur électrique 39 du dispositif de commande par signaux radiofréquences 37, est un conducteur électrique de phase.

En variante, le premier conducteur électrique 42 du câble d'alimentation électrique 18, relié électriquement au premier conducteur électrique 38 du dispositif de commande par signaux radiofréquences 37, est un conducteur électrique de phase. En outre, le deuxième conducteur électrique 43 du câble d'alimentation électrique 18, relié électriquement au deuxième conducteur électrique 39 du dispositif de commande par signaux radiofréquences 37, est un conducteur électrique de neutre.

Avantageusement, la carte de circuit imprimé 47 comprend la piste électrique matérialisant la première section de ligne d'adaptation 48 au niveau d'une première couche de celle-ci et un plan de masse réalisé au niveau d'une deuxième couche de celle-ci. La première couche est différente de la deuxième couche. Le plan de masse constitue la tension de référence 26.

Avantageusement, la première section de ligne d'adaptation 48 peut comprendre un coude, de sorte à être en forme de « L », comme illustré à la figure 4, plusieurs coudes, de sorte à être en forme de « U » inversé, ou être dépourvue de coude, de sorte à être en forme de « I », autrement dit de sorte à s'étendre selon une ligne droite.

Avantageusement, dans le cas où la première section de ligne d'adaptation 48 comprend un ou plusieurs coudes, la longueur L correspond à la somme des longueurs des branches de la première section de ligne d'adaptation 48.

Ici et comme illustré à la figure 4, la longueur L de la première section de ligne d'adaptation 48 correspond à la somme des longueurs L1, L2 des deux branches de la première section de ligne d'adaptation 48, étant donné que celle-ci comprend un coude.

En outre, dans le cas où la première section de ligne d'adaptation 48 est dépourvue de coude, autrement dit est rectiligne, la longueur L correspond à la longueur de l'unique branche de la première section de ligne d'adaptation 48.

Avantageusement, le dispositif de commande par signaux radiofréquences 37 comprend, en outre, une autre section de ligne d'adaptation 50 et un autre point de connexion 52.

Ici, l'autre section de ligne d'adaptation 50 est appelée par la suite deuxième section de ligne d'adaptation. En outre, l'autre point de connexion 52 est appelé par la suite deuxième point de connexion.

Le deuxième point de connexion 52 est disposé au niveau de la deuxième extrémité 39b du deuxième conducteur électrique 39.

La deuxième section de ligne d'adaptation 50 comprend une première extrémité 50a et une deuxième extrémité 50b. La première extrémité 50a est distincte et, en particulier, opposée à la deuxième extrémité 50b. La première extrémité 50a de la deuxième section de ligne d'adaptation 50 est reliée électriquement au deuxième point de connexion 52.

Ici, la deuxième extrémité 50b de la section de ligne d'adaptation 50 est reliée électriquement à la tension de référence 26.

En variante, non représentée, la deuxième extrémité 50b de la deuxième section de ligne d'adaptation 50 est dépourvue d'une connexion électrique, en particulier à un élément du dispositif de commande par signaux radiofréquences 37.

Avantageusement, la deuxième section de ligne d'adaptation 50 présente les mêmes caractéristiques, notamment physiques et géométriques, que la première section de ligne d'adaptation 48 décrite ci-dessus.

Ainsi, ce qui s'applique à la première section de ligne d'adaptation 48 peut s'appliquer également à la deuxième section de ligne d'adaptation 50.

Par conséquent, la deuxième section de ligne d'adaptation 50 est configurée pour ne pas être traversée, autrement dit n'est pas traversée, par le courant du réseau d'alimentation électrique du secteur circulant dans l'un des conducteurs électriques du réseau d'alimentation électrique du secteur 24, dans le deuxième conducteur électrique 43 du câble d'alimentation électrique 18, puis dans le deuxième conducteur électrique 39 du dispositif de commande par signaux radiofréquences 37.

De cette manière, les dimensions de la deuxième section de ligne d'adaptation 50 peuvent être minimisées, de même que celles de la carte de circuit imprimé 47.

Par ailleurs, la deuxième section de ligne d'adaptation 50 est configurée pour ne pas être traversée, autrement dit n'est pas traversée, par les signaux radiofréquences circulant dans l'un des conducteurs électriques du réseau d'alimentation électrique du secteur 24, dans le deuxième conducteur électrique 43 du câble d'alimentation électrique 18, dans le deuxième conducteur électrique 39 du dispositif de commande par signaux radiofréquences 37.

Avantageusement, les dimensions de la deuxième section de ligne d'adaptation 50 sont de petite taille, dans le cas où la fréquence de travail de l'unité radiofréquences 40 est supérieure à 1GHz, par exemple de l'ordre de 2,4GHz.

Avantageusement, les première et deuxième sections de ligne d'adaptation 48, 50 peuvent être de longueur L identique.

En variante, les première et deuxième sections de ligne d'adaptation 48, 50 peuvent être de longueurs L différentes, de sorte à adapter l'impédance sur le premier conducteur électrique 38 par rapport à l'impédance de l'antenne 25.

En outre, la deuxième section de ligne d'adaptation 50 permet d'isoler le deuxième conducteur électrique 39 du dispositif de commande par signaux radiofréquences 37 d'un point de vue radiofréquence, de sorte à ne pas perturber le fonctionnement de l'antenne 25 réalisée au moyen du premier conducteur électrique 42 du câble d'alimentation électrique 18 et d'au moins l'un des conducteurs électriques du réseau d'alimentation électrique du secteur 24.

La deuxième extrémité 48b de la première section de ligne d'adaptation 48 et la deuxième extrémité 50b de la deuxième section de ligne d'adaptation 50 peuvent être reliées électriquement à une même tension de référence 26.

Dans un tel cas, la tension de référence 26 peut être obtenue par un même plan de masse de la carte de circuit imprimé 47.

En variante, non représentée, chacune des deuxièmes extrémités 48b, 50b de la première section de ligne d'adaptation 48 et de la deuxième section de ligne d'adaptation 50 peuvent être reliées électriquement à une tension de référence différente.

Avantageusement, le dispositif de commande par signaux radiofréquences 37 comprend, en outre, au moins un élément d'isolation 54.

Ici, l'élément d'isolation 54 est appelé par la suite premier élément d'isolation.

Le premier élément d'isolation 54 est relié électriquement, d'une part, au deuxième point de connexion 52 et, d'autre part, à la tension de référence 26.

Ainsi, le premier élément d'isolation 54 permet d'obtenir une impédance élevée au niveau du deuxième conducteur électrique 39 du dispositif de commande par signaux radiofréquences 37 pour une fréquence de travail prédéterminée de l'unité radiofréquences 40.

En outre, le premier élément d'isolation 54 permet d'isoler, d'un point de vue radiofréquence, le deuxième conducteur électrique 43 du câble d'alimentation électrique 18 et le deuxième conducteur électrique 39 du dispositif de commande par signaux radiofréquences 37 par rapport à la tension de référence 26, de sorte à ne pas perturber le fonctionnement de l'antenne 25 réalisée au moyen du premier conducteur électrique 42 du câble d'alimentation électrique 18 et d'au moins l'un des conducteurs électriques du réseau d'alimentation électrique du secteur 24.

Ici, le premier élément d'isolation 54 est uniquement un condensateur.

En variante, non représentée, le premier élément d'isolation 54 est un circuit anti-résonnant, pouvant également être appelé « circuit bouchon ». En outre, le circuit anti-résonnant comprend un condensateur et une résistance.

Avantageusement, dans ce cas, le condensateur et la résistance peuvent être montés en série ou en parallèle.

Avantageusement, le dispositif de commande par signaux radiofréquences 37 comprend un autre élément d'isolation 55.

Ici, l'autre élément d'isolation 55 est appelé par la suite deuxième élément d'isolation.

Le deuxième élément d'isolation 55 est relié électriquement, d'une part, à la deuxième extrémité 50b de la deuxième section de ligne d'adaptation 50 et, d'autre part, à la tension de référence 26.

Ainsi, le deuxième élément d'isolation 55 permet d'isoler, d'un point de vue radiofréquence, le deuxième conducteur électrique 43 du câble d'alimentation électrique 18 et le deuxième conducteur électrique 39 du dispositif de commande par signaux radiofréquences 37 par rapport à la tension de référence 26, de sorte à ne pas perturber le fonctionnement de l'antenne 25 réalisée au moyen du premier conducteur électrique 42 du câble d'alimentation électrique 18 et d'au moins l'un des conducteurs électriques du réseau d'alimentation électrique du secteur 24.

Ici, le deuxième élément d'isolation 55 est uniquement un condensateur.

Dans ce premier mode de réalisation représenté à la figure 4, la deuxième extrémité 48b de la première section de ligne d'adaptation 48 est reliée électriquement directement à la tension de référence 26, c'est-à-dire sans interposition d'un composant électronique tel que, par exemple, un condensateur qui formerait un élément d'isolation. Cette connexion électrique directe entre la deuxième extrémité 48b de la première section de ligne d'adaptation 48 et la tension de référence 26 est due au fait que la première section de ligne d'adaptation 48 est reliée électriquement au premier conducteur électrique 38 du dispositif de commande par signaux radiofréquences 37, lui-même relié électriquement au premier conducteur électrique 42 du câble d'alimentation électrique 18, qui sont des conducteurs électriques de neutre, comme expliqué précédemment. En outre, la deuxième extrémité 50b de la deuxième section de ligne d'adaptation 50 est reliée électriquement à la tension de référence 26 par l'intermédiaire du deuxième élément d'isolation 55. Cette connexion électrique entre la deuxième extrémité 50b de la deuxième section de ligne d'adaptation 50 et la tension de référence 26 par l'intermédiaire du deuxième élément d'isolation 55 est due au fait que la deuxième section de ligne d'adaptation 50 est reliée électriquement au deuxième conducteur électrique 39 du dispositif de commande par signaux radiofréquences 37, lui-même relié électriquement au deuxième conducteur électrique 43 du câble d'alimentation électrique 18, qui sont des conducteurs électriques de phase, comme expliqué précédemment.

En variante, dans le cas où les conducteurs électriques de phase et de neutre sont inversés, la deuxième extrémité 48b de la première section de ligne d'adaptation 48 est reliée électriquement à la tension de référence 26 par l'intermédiaire d'un élément d'isolation. En outre, la deuxième extrémité 50b de la deuxième section de ligne d'adaptation 50 est reliée électriquement directement à la tension de référence 26.

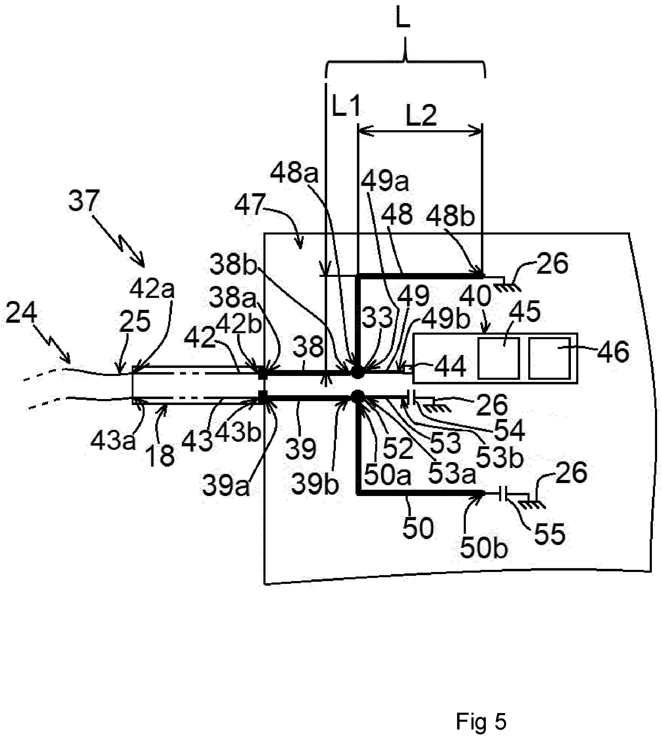

Dans le deuxième mode de réalisation, représenté à la figure 5, les éléments analogues à ceux du premier mode de réalisation portent les mêmes références et fonctionnent comme expliqué ci-dessus. Dans ce qui suit, on ne décrit, principalement, que ce qui distingue ce deuxième mode de réalisation du précédent. Dans ce qui suit, lorsqu'un signe de référence est utilisé sans être reproduit sur la figure 5, il correspond à l'objet portant la même référence sur l'une des figures 1 à 4.

On décrit maintenant, en référence à la figure 5, le dispositif de commande par signaux radiofréquences 37 selon le deuxième mode de réalisation de l'invention.

Le dispositif de commande par signaux radiofréquences 37 comprend, en outre, au moins une ligne de transport 49 des signaux radiofréquences.

Ici, la ligne de transport 49 est appelée par la suite première ligne de transport 49.

La première ligne de transport 49 est configurée pour transmettre les signaux radiofréquences. Toutefois, cette première ligne de transport n'est pas configurée pour adapter l'impédance de sortie et/ou d'entrée de l'unité radiofréquences 40 à l'impédance de l'antenne 25.

La première ligne de transport 49 comprend une première extrémité 49a et une deuxième extrémité 49b. La première extrémité 49a est distincte et, en particulier, opposée à la deuxième extrémité 49b. La première extrémité 49a de la première ligne de transport 49 est reliée électriquement au premier conducteur électrique 38 du dispositif de commande par signaux radiofréquences 37. En outre, la deuxième extrémité 49b de la première ligne de transport 49 est reliée électriquement à l'unité radiofréquences 40, en particulier à l'entrée et/ou sortie 44 de l'unité radiofréquences 40.

Avantageusement, la première extrémité 49a de la première ligne de transport 49 est reliée électriquement au premier point de connexion 33. Le point de connexion 33 est configuré pour être relié électriquement à l'unité radiofréquences 40.

Avantageusement, la carte de circuit imprimé 47 porte, autrement dit comprend, la première ligne de transport 49. En outre, la première ligne de transport 49 est formée par une piste électrique imprimée sur la carte de circuit imprimé 47.

Ainsi, la première ligne de transport 49 est une piste électrique de la carte de circuit imprimé 47.

Avantageusement, la première ligne de transport 49 est configurée pour être traversée, autrement dit est traversée, par le courant du réseau d'alimentation électrique du secteur 24 circulant dans l'un des conducteurs électriques du réseau d'alimentation électrique du secteur 24, dans le premier conducteur électrique 42 du câble d'alimentation électrique 18, puis dans le premier conducteur électrique 38 du dispositif de commande par signaux radiofréquences 37.

Avantageusement, le dispositif de commande par signaux radiofréquences 37 comprend une autre ligne de transport 53.

Ici, l'autre ligne de transport 53 est appelée par la suite deuxième ligne de transport.

La deuxième ligne de transport 53 comprend une première extrémité 53a et une deuxième extrémité 53b. La première extrémité 53a est distincte et, en particulier, opposée à la deuxième extrémité 53b. La première extrémité 53a de la deuxième ligne de transport 53 est reliée électriquement au deuxième conducteur électrique 39 du dispositif de commande par signaux radiofréquences 37. En outre, la deuxième extrémité 53b de la deuxième ligne de transport 53 est reliée électriquement à la tension de référence 26.

Avantageusement, la première extrémité 53a de la deuxième ligne de transport 53 est reliée électriquement au deuxième point de connexion 52.

Avantageusement, la deuxième ligne de transport 53 présente les mêmes caractéristiques que la première ligne de transport 49 décrite ci-dessus.

Ainsi, ce qui s'applique à la première ligne de transport 49 peut s'appliquer également à la deuxième ligne de transport 53.

En outre, la deuxième ligne de transport 53 permet d'isoler le deuxième conducteur électrique 39 du dispositif de commande par signaux radiofréquences 37 d'un point de vue radiofréquence, de sorte à ne pas perturber le fonctionnement de l'antenne 25 réalisée au moyen du premier conducteur électrique 42 du câble d'alimentation électrique 18 et d'au moins l'un des conducteurs électriques du réseau d'alimentation électrique du secteur 24.

Par ailleurs, la deuxième ligne de transport 53 est configurée pour ne pas absorber, autrement dit n'absorbe pas, au moins une partie de l'énergie radiofréquence des signaux radiofréquences circulant dans la première ligne de transport 49, étant donné que cette deuxième ligne de transport 53 est prévue pour présenter, autrement dit présente, une impédance élevée.

La deuxième extrémité 53b de la deuxième ligne de transport 53 peut être reliée électriquement à une même tension de référence 26 que la deuxième extrémité 48b de la première section de ligne d'adaptation 48 et la deuxième extrémité 50b de la deuxième section de ligne d'adaptation 50.

Dans un tel cas, la tension de référence 26 peut être obtenue par un même plan de masse de la carte de circuit imprimé 47.

En variante, non représentée, l'une ou plusieurs ou chacune des deuxièmes extrémités 48b, 50b, 53b de la première section de ligne d'adaptation 48, de la deuxième section de ligne d'adaptation 50 et de la deuxième ligne de transport 53 peuvent être reliées électriquement à une tension de référence différente.

Avantageusement, la deuxième ligne de transport 53 est configurée pour être traversée, autrement dit est traversée, par le courant du réseau d'alimentation électrique du secteur 24 circulant dans l'un des conducteurs électriques du réseau d'alimentation électrique du secteur 24, dans le deuxième conducteur électrique 43 du câble d'alimentation électrique 18, puis dans le deuxième conducteur électrique 39 du dispositif de commande par signaux radiofréquences 37.

En outre, le courant du réseau d'alimentation électrique du secteur 24 est configuré pour alimenter, autrement dit alimente, l'actionneur électromécanique 11 et, en particulier, le moteur électrique 16 de l'actionneur électromécanique 11 et l'unité électronique de contrôle 15.

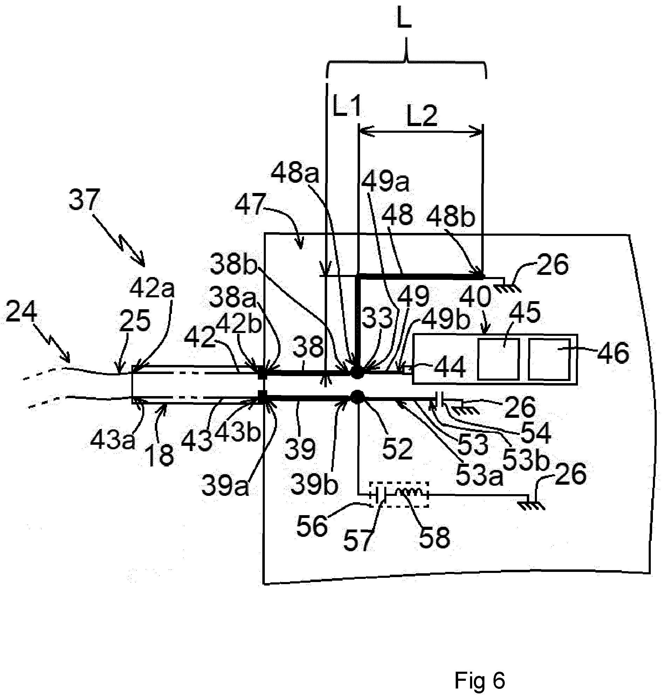

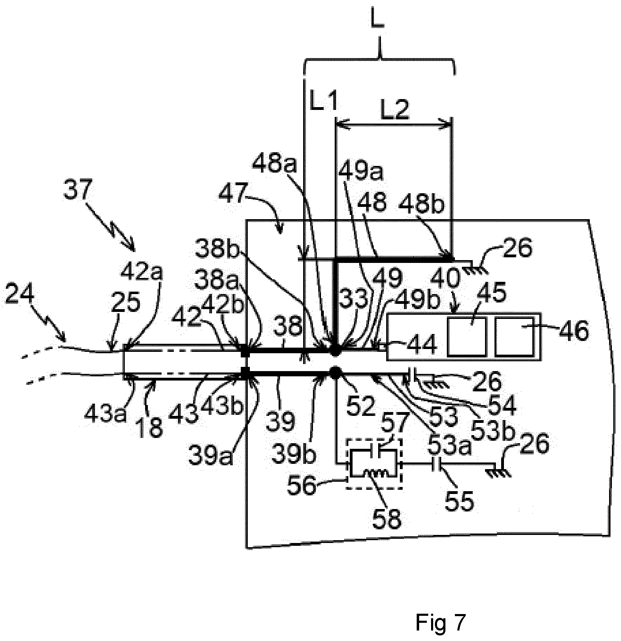

Dans les troisième et quatrième modes de réalisation, représentés respectivement aux figures 6 et 7, les éléments analogues à ceux du premier ou du deuxième mode de réalisation portent les mêmes références et fonctionnent comme expliqué ci-dessus. Dans ce qui suit, on ne décrit, principalement, que ce qui distingue ces troisième et quatrième modes de réalisation des précédents. Dans ce qui suit, lorsqu'un signe de référence est utilisé sans être reproduit sur la figure 6 ou sur la figure 7, il correspond à l'objet portant la même référence sur l'une des figures 1 à 5.

On décrit maintenant, en référence à la figure 6, le dispositif de commande par signaux radiofréquences 37 selon le troisième mode de réalisation de l'invention.

Le dispositif de commande par signaux radiofréquences 37 comprend, en outre, un circuit d'adaptation 56, en remplacement de la deuxième section de ligne d'adaptation 50. En outre, le circuit d'adaptation 56 est relié électriquement au deuxième point de connexion 52, disposé au niveau de la deuxième extrémité 39b du deuxième conducteur électrique 39.

Avantageusement, le circuit d'adaptation 56 comprend au moins un condensateur 57 et une inductance 58. Le condensateur 57 et l'inductance 58 sont reliés électriquement en série.

Ici, le point de connexion 52 est relié électriquement au condensateur 57 et le condensateur 57 est relié électriquement à l'inductance 58.

En variante, non représentée, le point de connexion 52 est relié électriquement à l'inductance 58 et l'inductance 58 est reliée électriquement au condensateur 57.

En outre, le circuit d'adaptation 56 est relié électriquement à la tension de référence 26.

La deuxième extrémité 48b de la première section de ligne d'adaptation 48 et le circuit d'adaptation 56 peuvent être reliés électriquement à une même tension de référence 26.

Dans un tel cas, la tension de référence 26 peut être obtenue par un même plan de masse de la carte de circuit imprimé 47.

En variante, non représentée, la deuxième extrémité 48b de la première section de ligne d'adaptation 48 et le circuit d'adaptation 56 peuvent être reliés électriquement à des tensions de référence différentes.

En variante, non représentée, le circuit d'adaptation 56 est relié électriquement au premier conducteur électrique 38 du dispositif de commande par signaux radiofréquences 37, lui-même relié électriquement au premier conducteur électrique 42 du câble d'alimentation électrique 18, les conducteurs électriques 38 et 42 étant des conducteurs électriques de neutre, comme expliqué précédemment. Dans ce cas, le deuxième conducteur électrique 39 du dispositif de commande par signaux radiofréquences 37 est lui-même relié électriquement au deuxième conducteur électrique 43 du câble d'alimentation électrique 18, les conducteurs électriques 39 et 43 étant des conducteurs électriques de phase, comme expliqué précédemment. En outre, dans ce cas, le condensateur 57 du circuit d'adaptation 56 est formé d'un seul composant électronique utilisé, d'une part, en tant que condensateur d'adaptation et, d'autre part, en tant que condensateur d'isolation électrique ou est composé d'un premier composant électronique d'adaptation, en particulier un condensateur d'adaptation, et d'un deuxième composant électronique d'isolation électrique, en particulier un condensateur d'isolation électrique. Ainsi, le condensateur 57 permet, d'une part, d'éviter un court-circuit électrique entre les premier et deuxième conducteurs électriques 38, 39 du dispositif de commande par signaux radiofréquences 37 et, d'autre part, de garantir une adaptation d'un point de vue radiofréquence du dispositif de commande par signaux radiofréquences 37.

Dans une autre variante, non représentée, où les conducteurs électriques de phase et de neutre sont inversés, le circuit d'adaptation 56 est relié électriquement au premier conducteur électrique 38 du dispositif de commande par signaux radiofréquences 37, lui-même relié électriquement au premier conducteur électrique 42 du câble d'alimentation électrique 18, les conducteurs électriques 38 et 42 étant des conducteurs électriques de phase. Dans ce cas, le deuxième conducteur électrique 39 du dispositif de commande par signaux radiofréquences 37 est lui-même relié électriquement au deuxième conducteur électrique 43 du câble d'alimentation électrique 18, les conducteurs électriques 39 et 43 étant des conducteurs électriques de neutre. En outre, dans ce cas, le condensateur 57 du circuit d'adaptation 56 présente les mêmes caractéristiques de fonctionnement que celles décrites ci-dessus, dans le cas où le premier conducteur électrique 38 du dispositif de commande par signaux radiofréquences 37 et le premier conducteur électrique 42 du câble d'alimentation électrique 18 sont des conducteurs électriques de neutre.

Le circuit d'adaptation 56 est configuré pour ne pas être traversé, autrement dit n'est pas traversé, par le courant du réseau d'alimentation électrique du secteur circulant dans l'un des conducteurs électriques du réseau d'alimentation électrique du secteur 24, dans le deuxième conducteur électrique 43 du câble d'alimentation électrique 18, puis dans le deuxième conducteur électrique 39 du dispositif de commande par signaux radiofréquences 37.

De cette manière, les dimensions du circuit d'adaptation 56 peuvent être minimisées, de même que celles de la carte de circuit imprimé 47.

Par ailleurs, le circuit d'adaptation 56 est configuré pour ne pas être traversé, autrement dit n'est pas traversé, par les signaux radiofréquences circulant dans l'un des conducteurs électriques du réseau d'alimentation électrique du secteur 24, dans le deuxième conducteur électrique 43 du câble d'alimentation électrique 18, dans le deuxième conducteur électrique 39 du dispositif de commande par signaux radiofréquences 37.

Avantageusement, les dimensions du circuit d'adaptation 56 sont de petite taille, pouvant être, par exemple, définies par une surface, notamment de forme carrée, présentant un côté de longueur inférieure ou égale à cinq millimètres ou par une surface, de forme rectangulaire, présentant une longueur inférieure ou égale à un millimètre et une largeur inférieure ou égale à un demi-millimètre. Ceci concerne notamment les dimensions de l'inductance 58, dans le cas où la fréquence de travail de l'unité radiofréquences 40 est supérieure à 1GHz, par exemple de l'ordre de 2,4GHz.

En outre, le circuit d'adaptation 56 permet d'isoler le deuxième conducteur électrique 39 du dispositif de commande par signaux radiofréquences 37 d'un point de vue radiofréquence, de sorte à ne pas perturber le fonctionnement de l'antenne 25 réalisée au moyen du premier conducteur électrique 42 du câble d'alimentation électrique 18 et d'au moins l'un des conducteurs électriques du réseau d'alimentation électrique du secteur 24.

Avantageusement, le dispositif de commande par signaux radiofréquences 37 peut comprendre, en outre, l'élément d'isolation 54, tel que décrit précédemment.

Toutefois, le dispositif de commande par signaux radiofréquences 37 est dépourvu du deuxième élément d'isolation 55 des premier et deuxième modes de réalisation. Ce deuxième élément d'isolation 55 est remplacé par le condensateur 57 du circuit d'adaptation 56, en particulier soit quand celui-ci est utilisé en tant que condensateur d'isolation électrique, soit par le deuxième composant électronique d'isolation électrique constituant une partie du condensateur 57 du circuit d'adaptation 56, comme cela est décrit précédemment.

Avantageusement, le dispositif de commande par signaux radiofréquences 37 peut comprendre, en outre, la première ligne de transport 49 et/ou la deuxième ligne de transport 53, tel que décrit précédemment en référence au deuxième mode de réalisation, ou être dépourvu de celles-ci, tel que décrit précédemment en référence au premier mode de réalisation.

On décrit maintenant, en référence à la figure 7, le dispositif de commande par signaux radiofréquences 37 selon le quatrième mode de réalisation de l'invention.

Ici, le condensateur 57 et l'inductance 58 du circuit d'adaptation 56 sont reliés électriquement en parallèle.

Dans ce cas, le circuit d'adaptation 56 présente globalement les mêmes caractéristiques de fonctionnement que celles décrites ci-dessus, dans le cas où le condensateur 57 et l'inductance 58 du circuit d'adaptation 56 sont reliés électriquement en série.

Ici, le point de connexion 52 est relié électriquement, d'une part, au condensateur 57 et, d'autre part, à l'inductance 58.

En outre, le circuit d'adaptation 56 est relié électriquement au deuxième élément d'isolation électrique 55, tel que décrit en référence aux premier et deuxième modes de réalisation.

Ici, le condensateur 57 et l'inductance 58 sont reliés respectivement au deuxième élément d'isolation électrique 55.

Comme dans le troisième mode de réalisation, la deuxième extrémité 48b de la première section de ligne d'adaptation 48 et le deuxième élément d'isolation électrique 55 peuvent être reliés électriquement à une même tension de référence 26 ou à des tensions de référence différentes.

En variante, non représentée, le circuit d'adaptation 56 est relié électriquement au premier conducteur électrique 38 du dispositif de commande par signaux radiofréquences 37, lui-même relié électriquement au premier conducteur électrique 42 du câble d'alimentation électrique 18, les conducteurs électriques 38 et 42 étant des conducteurs électriques de neutre, comme expliqué précédemment. Dans ce cas, le deuxième conducteur électrique 39 du dispositif de commande par signaux radiofréquences 37 est lui-même relié électriquement au deuxième conducteur électrique 43 du câble d'alimentation électrique 18, les conducteurs électriques 39 et 43 étant des conducteurs électriques de phase, comme expliqué précédemment. En outre, dans ce cas, le deuxième élément d'isolation 55 permet, d'une part, d'éviter un court-circuit électrique entre les premier et deuxième conducteurs électriques 38, 39 du dispositif de commande par signaux radiofréquences 37 et le circuit d'adaptation 56, constitué par le condensateur 57 et l'inductance 58 du circuit d'adaptation 56 reliés électriquement en parallèle, et, d'autre part, de garantir une adaptation d'un point de vue radiofréquence du dispositif de commande par signaux radiofréquences 37.

Dans une autre variante, non représentée, où les conducteurs électriques de phase et de neutre sont inversés, le circuit d'adaptation 56 est relié électriquement au premier conducteur électrique 38 du dispositif de commande par signaux radiofréquences 37, lui-même relié électriquement au premier conducteur électrique 42 du câble d'alimentation électrique 18, les conducteurs électriques 38 et 42 étant des conducteurs électriques de phase. Dans ce cas, le deuxième conducteur électrique 39 du dispositif de commande par signaux radiofréquences 37 est lui-même relié électriquement au deuxième conducteur électrique 43 du câble d'alimentation électrique 18, les conducteurs électriques 39 et 43 étant des conducteurs électriques de neutre. En outre, dans ce cas, le deuxième élément d'isolation électrique 55 et le circuit d'adaptation 56 présentent les mêmes caractéristiques de fonctionnement que celles décrites ci-dessus, dans le cas où le premier conducteur électrique 38 du dispositif de commande par signaux radiofréquences 37 et le premier conducteur électrique 42 du câble d'alimentation électrique 18 sont des conducteurs électriques de neutre.

A la lecture de ce qui a été décrit précédemment, un appareil électrique domestique, notamment l'actionneur électromécanique 11 pour le dispositif d'occultation 3, peut comprendre un dispositif de commande par signaux radiofréquences 37.

Une installation peut être configurée en comprenant plusieurs appareils électriques domestiques, notamment plusieurs actionneurs électromécaniques 11, tels que décrits précédemment et, éventuellement, plusieurs unités de commande 12, 13, locales ou centrales, et/ou plusieurs capteurs qui peuvent être configurés pour communiquer ensemble sur un même réseau radiofréquences, en utilisant un protocole commun et des moyens d'identification.

Grâce à la présente invention, quel que soit le mode de réalisation, la première section de ligne d'adaptation connectée électriquement au premier point de connexion disposé au niveau de la deuxième extrémité du premier conducteur électrique permet d'adapter une impédance sur le premier conducteur électrique par rapport à une impédance de l'antenne, d'empêcher un rejet des signaux radiofréquences entre les premier et deuxième conducteurs électriques du dispositif de commande par signaux radiofréquences, de réduire des pertes radiofréquences, du point de vue de la puissance et de la sensibilité, lors de la réception et/ou de l'émission des signaux radiofréquences par le dispositif de commande par signaux radiofréquences, tout en réduisant les dimensions de la carte de circuit imprimé.

Bien entendu, de nombreuses modifications peuvent être apportées aux exemples de réalisation décrits précédemment sans sortir du cadre de l'invention défini par les revendications ci-annexées.

En variante, non représentée, le dispositif de commande par signaux radiofréquences 37 est dépourvu de, autrement dit ne comprend pas le, premier conducteur électrique 38 et de deuxième conducteur électrique 39. Dans un tel cas, le premier point de connexion 33 est relié électriquement directement au premier conducteur électrique 42 du câble d'alimentation électrique 18, en particulier au moyen d'un connecteur électrique monté sur la carte de circuit imprimé 47, au niveau de la deuxième extrémité 42b du premier conducteur électrique 42 du câble d'alimentation électrique 18. En outre, le deuxième point de connexion 52 est relié électriquement directement au deuxième conducteur électrique 43 du câble d'alimentation électrique 18, en particulier au moyen d'un connecteur électrique monté sur la carte de circuit imprimé 47, au niveau de la deuxième extrémité 43b du deuxième conducteur électrique 43 du câble d'alimentation électrique 18. Ainsi, dans ce cas, les premier et deuxième conducteurs électriques 38, 39 sont remplacés par les premier et deuxième conducteurs électriques 42, 43 du câble d'alimentation électrique 18. Autrement dit, le premier conducteur électrique 38 et le premier conducteur électrique 42 ne forment qu'un même premier conducteur électrique. De même, le deuxième conducteur électrique 39 et le deuxième conducteur électrique 43 ne forment qu'un même deuxième conducteur électrique.

En variante, non représentée, le câble d'alimentation électrique 18 peut comprendre au moins trois conducteurs électriques, dont deux phases et un neutre. Dans un tel cas, une extrémité de chaque conducteur électrique du câble d'alimentation électrique 18 est configurée pour être reliée électriquement, autrement dit est reliée électriquement, à une première extrémité de l'un des conducteurs électriques du dispositif de commande par signaux radiofréquences 37, en particulier l'une des pistes électriques de la carte de circuit imprimé 47. En outre, une deuxième extrémité de chaque conducteur électrique du dispositif de commande par signaux radiofréquences 37 est reliée électriquement à un point de connexion distinct, tel que décrit précédemment.

L'invention est représentée sur les figures 4 et 5 dans le cas où l'appareil électrique domestique commandé par le dispositif de commande par signaux radiofréquences 37 est l'actionneur électromécanique 11 de l'installation 100 des figures 1 à 3. Ceci n'est toutefois pas obligatoire. En variante, cet appareil domestique électrique peut être un dispositif d'éclairage, un dispositif de chauffage, notamment un dispositif de chauffage de terrasse à infrarouge, et/ou de ventilation ou un dispositif d'alarme équipant un bâtiment ou son environnement extérieur, tel que le jardin. L'appareil électrique domestique comprenant le dispositif de commande par signaux radiofréquences peut également être un capteur de détection d'un paramètre météorologique, tel que l'ensoleillement, le vent ou l'humidité, un capteur de présence ou un capteur d'alarme. L'appareil électrique domestique comprenant le dispositif de commande par signaux radiofréquences peut également être un module d'alimentation en énergie électrique destiné à être logé à l'intérieur d'un boîtier électrique mural ou de plafond et configuré pour alimenter un dispositif d'éclairage, un dispositif de chauffage et/ou de ventilation, un dispositif d'alarme ou un dispositif d'occultation.

L'invention est représentée sur les figures 4 et 5 dans le cas où le dispositif de commande par signaux radiofréquences 37 est inclus en partie dans l'unité électronique de contrôle 15 de l'actionneur électromécanique 11, en particulier dans le premier module de communication 27. Ceci n'est toutefois pas obligatoire. En variante, le dispositif de commande par signaux radiofréquences 37 peut faire partie d'une unité électronique de contrôle distincte de l'unité électronique de contrôle 15 et/ou peut être disposé à l'extérieur du carter 17 de l'actionneur électromécanique 11 et, en particulier, montée sur le coffre 9 ou dans le support de couple 21.

En outre, les modes de réalisation et variantes envisagés peuvent être combinés pour générer de nouveaux modes de réalisation de l'invention, sans sortir du cadre de l'invention défini par les revendications ci-annexées.

## Revendications

1. Dispositif de commande par signaux radiofréquences (37) d'un appareil électrique domestique (11), l'appareil électrique domestique (11) étant configuré pour être alimenté en énergie électrique par un réseau d'alimentation électrique du secteur (24),
le dispositif de commande par signaux radiofréquences (37) comprenant au moins :
- un premier conducteur électrique (38 ; 42) et un deuxième conducteur électrique (39 ; 43), chacun des premier et deuxième conducteurs électriques (38, 39 ; 42, 43) comprenant une première extrémité (38a, 39a ; 42a, 43a) et une deuxième extrémité (38b, 39b ; 42b, 43b), la première extrémité (38a, 39a ; 42a, 43a) de chacun des premier et deuxième conducteurs électriques (38, 39 ; 42, 43) étant configurée pour être reliée électriquement au réseau d'alimentation électrique du secteur (24),
- une unité radiofréquences (40), l'unité radiofréquences (40) étant configurée pour recevoir et/ou émettre des signaux radiofréquences, l'unité radiofréquences (40) comprenant une entrée et/ou sortie (44) des signaux radiofréquences, l'unité radiofréquences (40) étant reliée électriquement à un point de connexion (33),
- une carte de circuit imprimé (47), la carte de circuit imprimé (47) comprenant au moins le point de connexion (33), et
- une antenne (25), l'antenne (25) étant reliée électriquement à l'unité radiofréquences (40) par l'intermédiaire d'au moins l'un des conducteurs électriques du réseau d'alimentation électrique du secteur (24),
**caractérisé**
**en ce que** le point de connexion (33) est disposé au niveau de la deuxième extrémité (38b ; 42b) du premier conducteur électrique (38 ; 42),
et **en ce que** le dispositif de commande par signaux radiofréquences (37) comprend, en outre, au moins une section de ligne d'adaptation (48), la section de ligne d'adaptation (48) comprenant une première extrémité (48a) et une deuxième extrémité (48b), la première extrémité (48a) de la section de ligne d'adaptation (48) étant reliée électriquement au point de connexion (33) et la deuxième extrémité (48b) de la section de ligne d'adaptation (48) étant soit reliée électriquement à une tension de référence (26) soit dépourvue d'une connexion électrique.

2. Dispositif de commande par signaux radiofréquences (37) d'un appareil électrique domestique (11) selon la revendication 1, **caractérisé en ce que** la première section de ligne d'adaptation (48) est une piste électrique de la carte de circuit imprimé (47).

3. Dispositif de commande par signaux radiofréquences (37) d'un appareil électrique domestique (11) selon la revendication 1 ou selon la revendication 2, **caractérisé en ce que** la section de ligne d'adaptation (48) présente une longueur (L) proche du quart de la longueur d'onde de la fréquence de travail de l'unité radiofréquences (40).

4. Dispositif de commande par signaux radiofréquences (37) d'un appareil électrique domestique (11) selon l'une quelconque des revendications 1 à 3, **caractérisé**
**en ce que** le dispositif de commande par signaux radiofréquences (37) comprend, en outre, une autre section de ligne d'adaptation (50) et un autre point de connexion (52), en ce que l'autre point de connexion (52) est disposé au niveau de la deuxième extrémité (39b ; 43b) du deuxième conducteur électrique (39 ; 43),
**en ce que** l'autre section de ligne d'adaptation (50) comprend une première extrémité (50a) et une deuxième extrémité (50b),
**en ce que** la première extrémité (50a) de l'autre section de ligne d'adaptation (50) est reliée électriquement à l'autre point de connexion (52),
et **en ce que** la deuxième extrémité (50b) de l'autre section de ligne d'adaptation (50) est soit dépourvue d'une connexion électrique soit reliée électriquement à une tension de référence (26).

5. Dispositif de commande par signaux radiofréquences (37) d'un appareil électrique domestique (11) selon l'une quelconque des revendications 1 à 3, **caractérisé**
**en ce que** le dispositif de commande par signaux radiofréquences (37) comprend, en outre, un circuit d'adaptation (56) et un autre point de connexion (52),
**en ce que** l'autre point de connexion (52) est disposé au niveau de la deuxième extrémité (39b ; 43b) du deuxième conducteur électrique (39 ; 43),
**en ce que** le circuit d'adaptation (56) est relié électriquement, d'une part, à l'autre point de connexion (52) et, d'autre part, est soit relié électriquement à une tension de référence (26) soit au premier conducteur électrique (38 ; 42).

6. Dispositif de commande par signaux radiofréquences (37) d'un appareil électrique domestique (11) selon l'une quelconque des revendications 1 à 5, **caractérisé**
**en ce que** le dispositif de commande par signaux radiofréquences (37) comprend, en outre, au moins une ligne de transport (49) des signaux radiofréquences,
**en ce que** la ligne de transport (49) comprend une première extrémité (49a) et une deuxième extrémité (49b),
**en ce que** la première extrémité (49a) de la ligne de transport (49) est reliée électriquement au premier conducteur électrique (38 ; 42),
et **en ce que** la deuxième extrémité (49b) de la ligne de transport (49) est reliée électriquement à l'unité radiofréquences (40).

7. Dispositif de commande par signaux radiofréquences (37) d'un appareil électrique domestique (11) selon la revendication 6, **caractérisé en ce que** la première extrémité (49a) de la ligne de transport (49) est reliée électriquement au point de connexion (33), le point de connexion (33) étant configuré pour être relié électriquement à l'unité radiofréquences (40).

8. Dispositif de commande par signaux radiofréquences (37) d'un appareil électrique domestique (11) selon la revendication 6 ou selon la revendication 7, **caractérisé**
**en ce que** la carte de circuit imprimé (47) porte la ligne de transport (49),
et **en ce que** la ligne de transport (49) est formée par une piste électrique imprimée sur la carte de circuit imprimé (47).

9. Dispositif de commande par signaux radiofréquences (37) d'un appareil électrique domestique (11) selon l'une quelconque des revendications 1 à 8, **caractérisé en ce que** le dispositif de commande par radiofréquences (37) est dépourvu d'un coupleur disposé entre le premier conducteur électrique (38, 42) et l'unité radiofréquences (40).

10. Appareil électrique domestique, caractérisé en que l'appareil électrique domestique comprend au moins un dispositif de commande par signaux radiofréquences (37) conforme à l'une quelconque des revendications 1 à 9.

11. Appareil électrique domestique selon la revendication 10, **caractérisé en ce que** l'appareil électrique domestique est un actionneur électromécanique (11) pour un dispositif d'occultation (3).

12. Appareil électrique domestique selon la revendication 10, **caractérisé en ce que** l'appareil électrique domestique est un module d'alimentation en énergie électrique, le module d'alimentation en énergie électrique étant destiné à être logé à l'intérieur d'un boîtier électrique mural ou de plafond et étant configuré pour alimenter en énergie électrique un dispositif d'éclairage, un dispositif de chauffage et/ou de ventilation, un dispositif d'alarme ou un dispositif d'occultation (3).

13. Dispositif d'occultation (3), caractérisé en que le dispositif d'occultation (3) comprend au moins un actionneur électromécanique (11) formé par un appareil électrique domestique conforme à la revendication 10.

## Patentansprüche

1. Hochfrequenzsignalsteuerungsvorrichtung (37) eines elektrischen Haushaltsgeräts (11), wobei das elektrische Haushaltsgerät (11) konfiguriert ist, um von einem Stromversorgungsnetz des Netzes (24) mit elektrischer Energie versorgt zu werden,
die Hochfrequenzsignalsteuerungsvorrichtung (37) mindestens umfassend:
- einen ersten elektrischen Leiter (38; 42) und einen zweiten elektrischen Leiter (39; 43), jeder von dem ersten und dem zweiten elektrischen Leiter (38, 39; 42, 43) umfassend ein erstes Ende (38a, 39a; 42a, 43a) und ein zweites Ende (38b, 39b; 42b, 43b), das erste Ende (38a, 39a; 42a, 43a) von jedem von dem ersten und dem zweiten elektrischen Leiter (38, 39; 42, 43) konfiguriert ist, um elektrisch mit dem Stromversorgungsnetz des Netzes (24) verbunden zu sein,
- eine Hochfrequenzeinheit (40), wobei die Hochfrequenzeinheit (40) konfiguriert ist, um Hochfrequenzsignale zu empfangen und/oder zu senden, die Hochfrequenzeinheit (40) umfassend einen Eingang und/oder Ausgang (44) für Hochfrequenzsignale, wobei die Hochfrequenzeinheit (40) elektrisch mit einem Verbindungspunkt (33) verbunden ist,
- eine Leiterplatte (47), die Leiterplatte (47) umfassend mindestens den Verbindungspunkt (33), und
- eine Antenne (25), wobei die Antenne (25) über mindestens einen der elektrischen Leiter des Stromversorgungsnetzes des Netzes (24) elektrisch mit der Hochfrequenzeinheit (40) verbunden ist,
**dadurch gekennzeichnet,**
**dass** der Verbindungspunkt (33) an dem zweiten Ende (38b; 42b) des ersten elektrischen Leiters (38; 42) angeordnet ist,
und **dass** die Hochfrequenzsignalsteuerungsvorrichtung (37) ferner mindestens einen Anpassungsleitungsabschnitt (48) umfasst, der Anpassungsleitungsabschnitt (48) ein erstes Ende (48a) und ein zweites Ende (48b) umfasst, das erste Ende (48a) des Anpassungsleitungsabschnitts (48) elektrisch mit dem Verbindungspunkt (33) verbunden ist und das zweite Ende (48b) des Anpassungsleitungsabschnitts (48) entweder elektrisch mit einer Referenzspannung (26) verbunden ist oder keine elektrische Verbindung aufweist.

2. Hochfrequenzsignalsteuerungsvorrichtung (37) eines elektrischen Haushaltsgeräts (11) nach Anspruch 1, **dadurch gekennzeichnet, dass** der erste Anpassungsleitungsabschnitt (48) eine Leiterbahn der Leiterplatte (47) ist.

3. Hochfrequenzsignalsteuerungsvorrichtung (37) eines elektrischen Haushaltsgeräts (11) nach Anspruch 1 oder nach Anspruch 2, **dadurch gekennzeichnet, dass** der Anpassungsleitungsabschnitt (48) eine Länge (L) aufweist, die nahe bei einem Viertel der Wellenlänge der Betriebsfrequenz der Hochfrequenzeinheit (40) ist.

4. Hochfrequenzsignalsteuerungsvorrichtung (37) eines elektrischen Haushaltsgeräts (11) nach einem der Ansprüche 1 bis 3, **dadurch gekennzeichnet**
**dass** die Hochfrequenzsignalsteuerungsvorrichtung (37) ferner einen weiteren Anpassungsleitungsabschnitt (50) und einen weiteren Verbindungspunkt (52) umfasst, dass der andere Verbindungspunkt (52) an dem zweiten Ende (39b; 43b) des zweiten elektrischen Leiters (39; 43) angeordnet ist,
**dass** der andere Anpassungsleitungsabschnitt (50) ein erstes Ende (50a) und ein zweites Ende (50b) umfasst,
**dass** das erste Ende (50a) des anderen Anpassungsleitungsabschnitts (50) elektrisch mit dem anderen Verbindungspunkt (52) verbunden ist,
und **dass** das zweite Ende (50b) des anderen Anpassungsleitungsabschnitts (50) entweder keine elektrische Verbindung aufweist oder elektrisch mit einer Referenzspannung (26) verbunden ist.

5. Hochfrequenzsignalsteuerungsvorrichtung (37) eines elektrischen Haushaltsgeräts (11) nach einem der Ansprüche 1 bis 3, **dadurch gekennzeichnet**
**dass** die Hochfrequenzsignalsteuerungsvorrichtung (37) ferner eine Anpassungsschaltung (56) und einen weiteren Verbindungspunkt (52) umfasst,
**dass** der andere Verbindungspunkt (52) an dem zweiten Ende (39b; 43b) des zweiten elektrischen Leiters (39; 43) angeordnet ist,
**dass** die Anpassungsschaltung (56) einerseits elektrisch mit dem anderen Verbindungspunkt (52) verbunden ist und andererseits elektrisch entweder mit einer Referenzspannung (26) oder mit dem ersten elektrischen Leiter (38; 42) verbunden ist.

6. Hochfrequenzsignalsteuerungsvorrichtung (37) eines elektrischen Haushaltsgeräts (11) nach einem der Ansprüche 1 bis 5, **dadurch gekennzeichnet**
**dass** die Hochfrequenzsignalsteuerungsvorrichtung (37) ferner mindestens eine Transportleitung (49) für Hochfrequenzsignale umfasst,
**dass** die Transportleitung (49) ein erstes Ende (49a) und ein zweites Ende (49b) umfasst,
**dass** das erste Ende (49a) der Transportleitung (49) elektrisch mit dem ersten elektrischen Leiter (38; 42) verbunden ist,
und **dass** das zweite Ende (49b) der Übertragungsleitung (49) elektrisch mit der Hochfrequenzeinheit (40) verbunden ist.

7. Hochfrequenzsignalsteuerungsvorrichtung (37) eines elektrischen Haushaltsgeräts (11) nach Anspruch 6, **dadurch gekennzeichnet, dass** das erste Ende (49a) der Transportleitung (49) elektrisch mit dem Verbindungspunkt (33) verbunden ist, wobei der Verbindungspunkt (33) konfiguriert ist, um elektrisch mit der Hochfrequenzeinheit (40) verbunden zu sein.

8. Hochfrequenzsignalsteuerungsvorrichtung (37) eines elektrischen Haushaltsgeräts (11) nach Anspruch 6 oder nach Anspruch 7, **dadurch gekennzeichnet**
**dass** die Leiterplatte (47) die Transportleitung (49) trägt,
und **dass** die Transportleitung (49) durch eine auf der Leiterplatte (47) gedruckte elektrische Leiterbahn gebildet ist.

9. Hochfrequenzsignalsteuerungsvorrichtung (37) eines elektrischen Haushaltsgeräts (11) nach einem der Ansprüche 1 bis 8, **dadurch gekennzeichnet, dass** die Hochfrequenz-Steuerungsvorrichtung (37) keinen Koppler aufweist, der zwischen dem ersten elektrischen Leiter (38, 42) und der Radiofrequenzeinheit (40) angeordnet ist.

10. Elektrisches Haushaltsgerät, **dadurch gekennzeichnet, dass** das elektrische Haushaltsgerät mindestens eine Hochfrequenzsignalsteuerungsvorrichtung (37) gemäß einem der Ansprüche 1 bis 9 umfasst.

11. Elektrisches Haushaltsgerät nach Anspruch 10, **dadurch gekennzeichnet, dass** das elektrische Haushaltsgerät ein elektromechanischer Aktuator (11) für eine Abdeckvorrichtung (3) ist.

12. Elektrisches Haushaltsgerät nach Anspruch 10, **dadurch gekennzeichnet, dass** das elektrische Haushaltsgerät ein Stromversorgungsmodul ist, wobei das Stromversorgungsmodul dazu bestimmt ist, im Inneren eines Schaltkastens an der Wand oder Decke untergebracht zu sein, und konfiguriert ist, um eine Beleuchtungsvorrichtung, eine Heizungs- und/oder Belüftungsvorrichtung, eine Alarmanlage oder eine Abdeckvorrichtung (3) mit Strom zu versorgen.

13. Abdeckvorrichtung (3), **dadurch gekennzeichnet, dass** die Abdeckvorrichtung (3) mindestens einen elektromechanischen Aktuator (11) umfasst, der durch ein elektrisches Haushaltsgerät gemäß Anspruch 10 gebildet ist.

## Claims

1. A radiofrequency signal control device (37) of a domestic electrical apparatus (11), the domestic electrical apparatus (11) being configured to be supplied with electrical energy from a mains electrical supply network (24),
the radiofrequency signal control device (37) comprising at least:
- a first electrical conductor (38; 42) and a second electrical conductor (39; 43), each of the first and second electrical conductors (38, 39; 42, 43) comprising a first end (38a, 39a; 42a, 43a) and a second end (38b, 39b; 42b, 43b), the first end (38a, 39a; 42a, 43a) of each of the first and second electrical conductors (38, 39; 42, 43) being configured to be electrically connected to the mains electrical supply network (24),
- a radiofrequency unit (40), the radiofrequency unit (40) being configured to receive and/or emit radiofrequency signals, the radiofrequency unit (40) comprising an input and/or an output (44) of the radiofrequency signals, the radiofrequency unit (40) being electrically connected to a connection point (33),
- a printed circuit board (47), the printed circuit board (47) comprising at least the connection point (33), and
- an antenna (25), the antenna (25) being electrically connected to the radiofrequency unit (40) by at least one of the electrical conductors of the mains electrical supply network (24),
**characterized**
**in that** the connection point (33) is arranged at the second end (38b; 42b) of the first electrical conductor (38; 42),
and **in that** the radiofrequency signal control device (37) further comprises at least one adaptation line section (48), the adaptation line section (48) comprising a first end (48a) and a second end (48b), the first end (48a) of the adaptation line section (48) being electrically connected to the connection point (33) and the second end (48b) of the adaptation line section (48) being either electrically connected to a reference voltage (26) or is devoid of an electrical connection.

2. The radiofrequency signal control device (37) of a domestic electrical apparatus (11) according to claim 1, **characterized in that** the first adaptation line section (48) is an electrical track of the printed circuit board (47).

3. The radiofrequency signal control device (37) of a domestic electrical apparatus (11) according to claim 1 or according to claim 2, **characterized in that** the adaptation line section (48) has a length (L) close to a quarter of the wavelength of the working frequency of the radiofrequency unit (40).

4. The radiofrequency signal control device (37) of a domestic electrical apparatus (11) according to any one of claims 1 to 3, **characterized**
**in that** the radiofrequency signal control device (37) further comprises another adaptation line section (50) and another connection point (52),
**in that** the other connection point (52) is arranged at the second end (39b; 43b) of the second electrical conductor (39; 43),
**in that** the other adaptation line section (50) comprises a first end (50a) and a second end (50b),
**in that** the first end (50a) of the other adaptation line section (50) is electrically connected to the other connection point (52),
and **in that** the second end (50b) of the other adaptation line section (50) either is devoid of an electrical connection or is electrically connected to a reference voltage (26).

5. The radiofrequency signal control device (37) of a domestic electrical apparatus (11) according to any one of claims 1 to 3, **characterized**
**in that** the radiofrequency signal control device (37) further comprises an adaptation circuit (56) and another connection point (52),
**in that** the other connection point (52) is arranged at the second end (39b; 43b) of the second electrical conductor (39; 43),
**in that** the adaptation circuit (56) is electrically connected, on the one hand, to the other connection point (52) and, on the other hand, is either electrically connected to a reference voltage (26) or to the first electrical conductor (38; 42).

6. The radiofrequency signal control device (37) of a domestic electrical apparatus (11) according to any one of claims 1 to 5, **characterized**
**in that** the radiofrequency signal control device (37) further comprises at least one transport line (49) of radiofrequency signal,
**in that** the transport line (49) comprises a first end (49a) and a second end (49b),
**in that** the first end (49a) of the transport line (49) is electrically connected to the first electrical conductor (38; 42),
and **in that** the second end (49b) of the transport line (49) is electrically connected to the radiofrequency unit (40).

7. The radiofrequency signal control device (37) of a domestic electrical apparatus (11) according to claim 6, **characterized in that** the first end (49a) of the transport line (49) is electrically connected to the connection point (33), the connection point (33) being configured to be electrically connected to the radiofrequency unit (40).

8. The radiofrequency signal control device (37) of a domestic electrical apparatus (11) according to claim 6 or according to claim 7, **characterized**
**in that** the printed circuit board (47) carries the transport line (49),
and **in that** the transport line (49) is formed by an electrical track printed on the printed circuit board (47).

9. The radiofrequency signal control device (37) of a domestic electrical apparatus (11) according to any one of claims 1 to 8, **characterized in that** the radiofrequency signal control device (37) is devoid of a coupler arranged between the first electrical conductor (38, 42) and the radiofrequency unit (40).

10. A domestic electrical apparatus, **characterized in that** the domestic electrical apparatus comprises at least a radiofrequency signal control device (37) according to any one of claims 1 to 9.

11. The domestic electrical apparatus according to claim 10, **characterized in that** the domestic electrical apparatus is an electromechanical actuator (11) for an occultation device (3).

12. The domestic electrical apparatus according to claim 10, **characterized in that** the domestic electrical apparatus is an electrical power supply module, the electrical power supply module being intended to be housed within an electrical wall or ceiling box and being configured to supply electrical energy to a lighting device, a heating and/or ventilation device, an alarm device or an occultation device (3).

13. An occultation device (3), **characterized in that** the occultation device (3) comprises at least an electromechanical actuator (11) formed by a domestic electrical apparatus according to claim 10.
